(19) Europäisches Patentamt
European Patent Office
Office européen des brevets

(11) **EP 2 525 498 A1**

(12) **EUROPEAN PATENT APPLICATION**

(43) Date of publication:
**21.11.2012 Bulletin 2012/47**

(51) Int Cl.:
*H03M 13/25* (2006.01)      *H03M 13/27* (2006.01)
*H03M 13/35* (2006.01)

(21) Application number: **11004127.4**

(22) Date of filing: **18.05.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Panasonic Corporation
Kadoma-shi
Osaka 571-8501 (JP)**

(72) Inventor: **Petrov, Mihail
63225 Langen (DE)**

(74) Representative: **Grünecker, Kinkeldey,
Stockmair & Schwanhäusser
Leopoldstrasse 4
80802 München (DE)**

(54) **Bit-interleaved coding and modulation (BICM) with quasi-cyclic LDPC codes**

(57)    The present invention relates to bit interleaving and de-interleaving of quasi-cyclic low-density parity-check (QC-LDPC) codes and discloses a bit interleaver that allows for a particularly efficient hardware implementation due to its high degree of parallelism. This is achieved by constructing a permutation for mapping the bits of the QC-LDPC codeword to a sequence of constellation words such that the permutation can be performed independently for each of $F \cdot N/M$ sections of the codeword, wherein N is the number of cyclic blocks within the codeword, M the number of bits per constellation word, and F the number of cyclic group bits that are mapped onto the same constellation word. According to a further aspect of the present invention, all bits of a given cyclic block are mapped to constellation word bits that have the same robustness level within the given set of predefined constellation points. A particularly important example is F=2 in case of a QAM constellation.

# Fig. 27B

**With folding**

**Description**

TECHNICAL FIELD

The present invention relates to the field of digital communications, and more specifically to bit interleavers for bit-interleaved coding and modulation systems with quasi-cyclic low-density parity-check codes.

BACKGROUND OF THE INVENTION

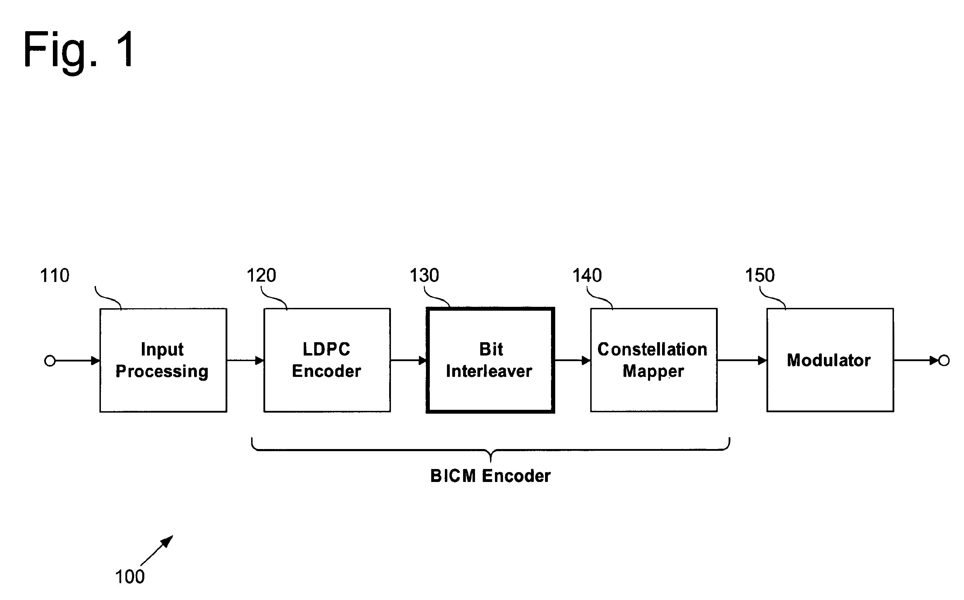

Figure 1 is a block diagram of a transmitter-side communication chain involving bit-interleaved coding and modulation (BICM). The input processing unit 110 formats the input bitstream into blocks of a predetermined length, which are then encoded by the low-density parity-check code (LDPC) encoder (120) and fed to bit interleaver 130. The LDPC encoded and interleaved data block is then subdivided into a sequence of cell words (constellation words), which are mapped to a sequence of constellations, e.g. QAM, by constellation mapper 140. The generic modulator 150 at the output includes all the processing blocks from the output of the BICM encoder to the RF power amplifier.

An LDPC code is a linear error correcting code that is fully defined by its parity-check matrix (PCM), which is a binary sparse matrix that represents the connection of the codeword bits (also referred to as variable nodes) to the parity checks (also referred to as check nodes). The columns and the rows of the PCM correspond to the variable and the check nodes respectively. Connections of the variable nodes to the check nodes are represented by "1" entries in the PCM.

Quasi-cyclic (QC) LDPC codes have a structure that makes them particularly suitable for hardware implementation. In fact, most if not all standards today use quasi-cyclic LDPC codes. The PCM of such a code has a special structure consisting of circulant matrices (also referred to as circulants). A circulant is a square matrix in which each row is a cyclic shift of the previous row with one position, and can have one, two, or more folded diagonals. The size of each circulant is QxQ, where Q is referred to as the cyclic factor of the LDPC code. Such a quasi-cyclic structure allows Q check nodes to be processed in parallel, which is clearly advantageous for an efficient hardware implementations.

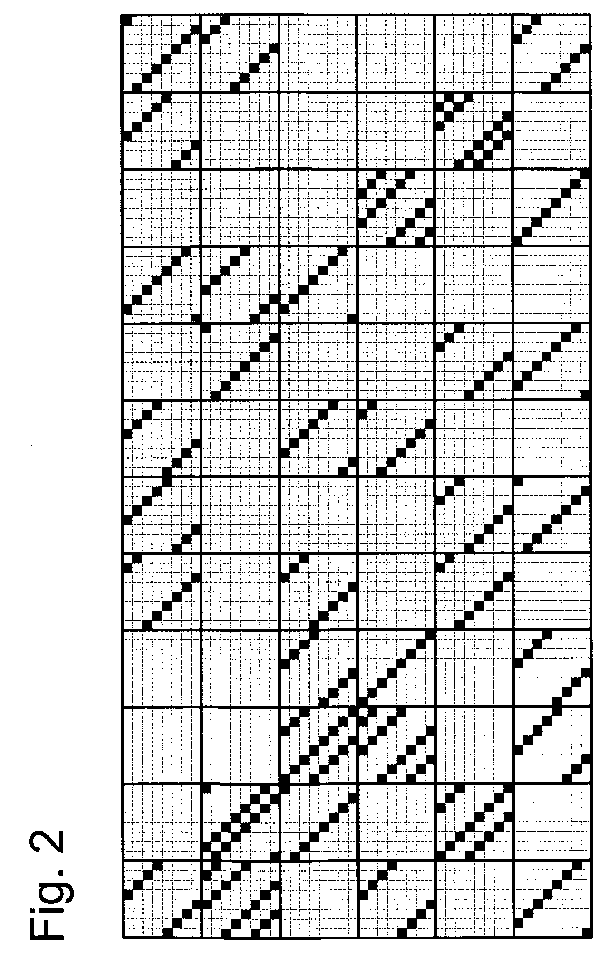

Fig. 2 shows the PCM of an example LDPC code with cyclic factor Q=8, the PCM having circulants with one or two diagonals. This code encodes a block of 8x6=48 bits to a codeword of 8x12=96 bits, having therefore a code rate of 48/96=1/2. The codeword bits are subdivided into blocks of Q bits, which will be referred to as cyclic blocks (or cyclic groups) throughout this document.

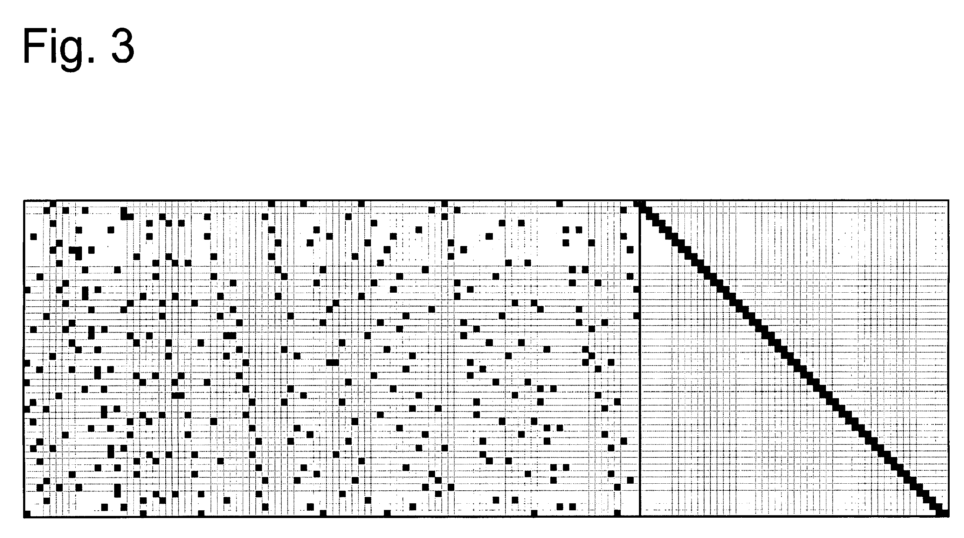

A special family of QC LDPC codes are the repeat-accumulate (RA) QC LDPC codes. These codes are well known for their ease of encoding and are encountered in a large number of standards, such as the second-generation DVB standards: DVB-S2, DVB-T2, and DVB-C2. The right-hand side part of the PCM, which corresponds to the parity bits, has a staircase structure, as shown in Fig. 3 for an example LDPC code of rate 2/3.

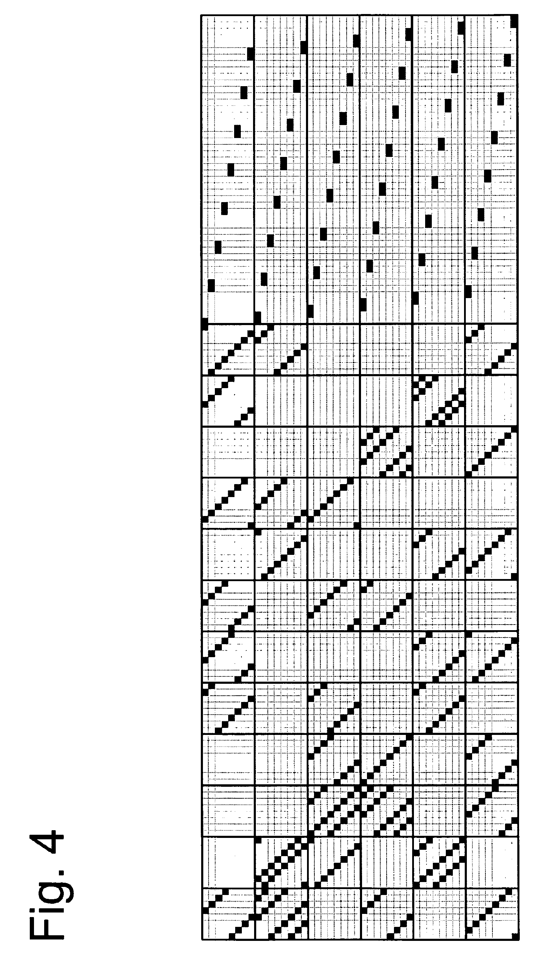

By applying a simple permutation to the PCM rows, the quasi-cyclic structure of the code is revealed, with the exception of the parity part, as shown in Fig. 4. The row permutation is just a change of the graphical representation with no impact on the code definition.

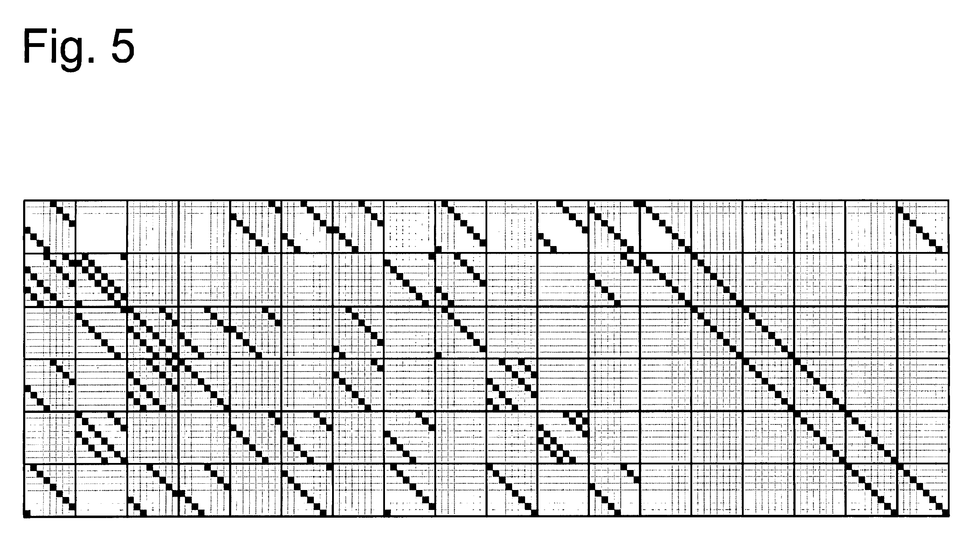

The parity part of the matrix can also be turned into a quasi-cyclic structure by applying a suitable permutation on the parity bits only. This technique is well known in the art and is used for example in the DVB-T2 standard under the name of parity interleaving or parity permutation. The resulting PCM is shown in Fig. 5.

Typically, the bits of an LDPC codeword have different importance levels, and the bits of a constellation have different robustness levels. A direct, i.e. non-interleaved, mapping of the LDPC codeword bits to the constellation bits leads to a suboptimal performance. That is why the codeword bits need to be interleaved prior to being mapped onto constellations.

For this purpose, a bit interleaver 130 is used between the LDPC encoder 120 and the constellation mapper 140, as illustrated in Fig. 1. By carefully designing the interleaver, an improved association can be achieved between the bits of the LDPC codeword and the bits encoded by the constellation, which leads to an improved performance. A typical measure of the performance is the bit-error rate (BER) as a function of the signal-to-noise ratio (SNR).

The different importance levels of the bits of an LDPC codeword result primarily from the fact that not all the bits are involved in the same number of parity checks. The more parity checks (check nodes) a codeword bit (variable node) is involved in, the more important that bit is in the iterative LDPC decoding process. A further reason is the fact that the variable nodes have different connectivities to the cycles in the Tanner graph representation of the LDPC code, so they may have different importance levels even when they are involved in the same number of parity checks. These aspects are well understood in the art. As a general rule, the importance level of a variable node increases with the number of check nodes it is connected to.

In the particular case of quasi-cyclic LDPC codes, all bits in a cyclic block of Q bits have the same importance since all of them are involved in the same number of parity checks and have the same connectivity to the cycles in the Tanner graph.

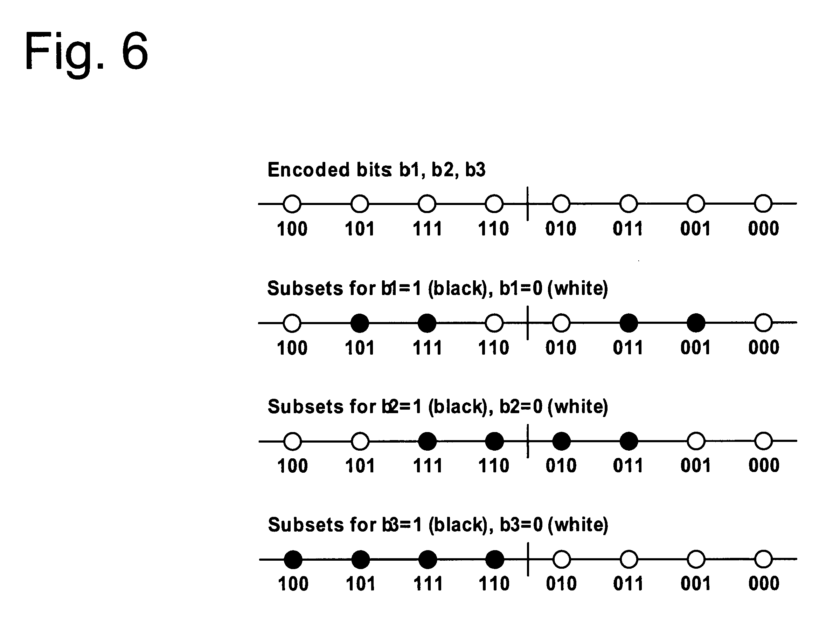

Likewise, the different robustness levels of the bits encoded in a constellation are a well known fact. For instance, a complex quadrature amplitude modulation (QAM) constellation consists of two independent pulse amplitude modulation (PAM) symbols, one for the real part and one for the imaginary part. Each of the two PAM symbols encodes the same number of bits M. The bits encoded in a PAM symbol have different robustness levels, as shown in Fig. 6 for an 8PAM symbol with Gray encoding. The different robustness levels result from the fact that the distance between the two subsets defined by each bit (0 or 1) is different for each bit. The larger the distance, the more robust or reliable the bit. In Fig. 6 bit b3 is the most robust, whereas bit b1 is the least robust.

Thus, a 16QAM constellation encodes four bits and has two robustness levels. A 64QAM constellation encodes six bits and has three robustness levels. A 256QAM constellation encodes eight bits and has four robustness levels.

For illustration purposes, the following parameters will be used throughout this document.

- Cyclic factor: Q = 8

- Number of cyclic blocks per LDPC codeword: N = 12

- Number of bits per constellation: M = 4, i.e. 16QAM

The resulting number of constellations per LDPC codeword is thus QN/M=24. Typically, the parameters Q and N must be chosen so that QN is a multiple of M for all the constellations supported by the system.

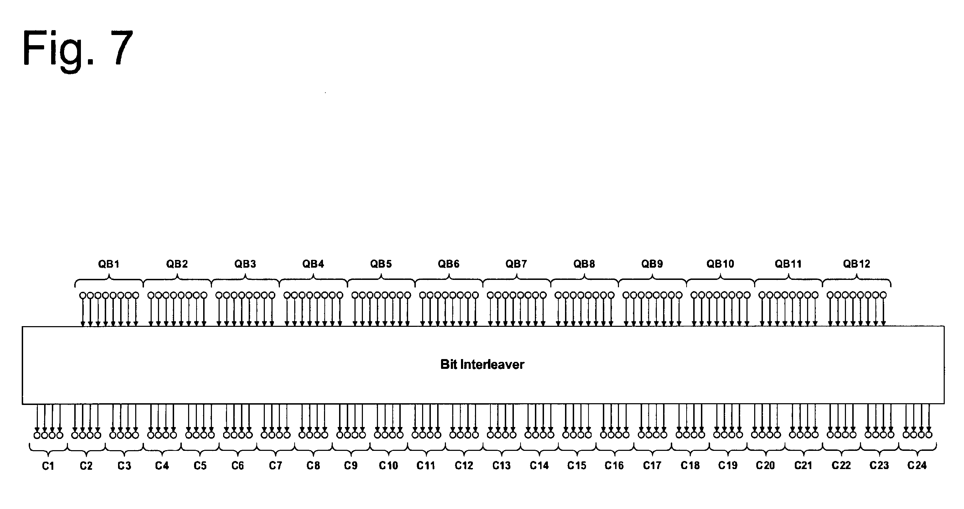

Fig. 7 shows a generic interleaver for the above parameters, where QB1...QB12 are the 12 cyclic blocks and C1...C24 are the 24 constellations.

A conventional bit interleaver is known from the DVB-T2 (Digital Video Broadcasting - Second Generation Terrestrial) standard (ETSI EN 302.755). DVB-T2 is an improvement of the television standard DVB-T, and describes a second-generation baseline transmission system for digital terrestrial television broadcasting. It specifies the channel coding and modulation system intended for transmitting digital television services and generic data.

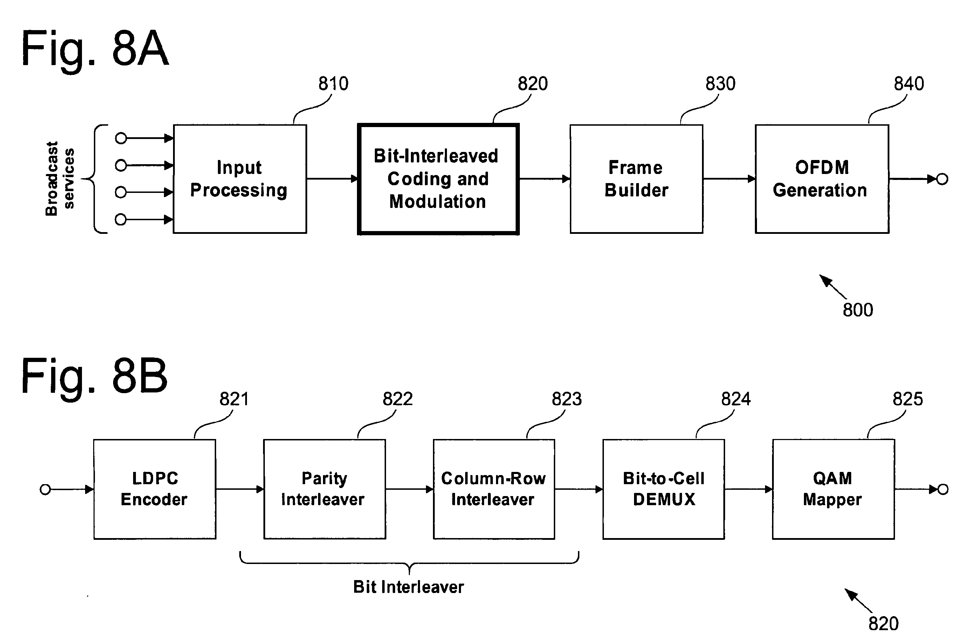

Fig. 8A shows the system overview of a DVB-T2 modulator, which includes a block 820 for bit-interleaved coding and modulation (BICM) encoding. The BICM used in DVB-T2 is described in Chapter 6 of the standard ETSI EN 302.755, which is incorporated herein by reference and explained herebelow.

Fig. 8B shows a schematic block diagram for the BICM encoder 820 as used in DVB-T2, but without outer BCH encoding, constellation rotation, cell interleaver, time interleaver, etc. The procedure for BICM encoding according to DVB-T2 comprises the steps of: LDPC encoding 821, interleaving the bits of the resulting codeword 822, 823, demultiplexing the interleaved bits into cell words 824, followed by mapping said cell words onto complex QAM (quadrature amplitude modulation) symbols 825, which are also referred to as cells. In fact, the bit-to-cell demux 824 can also be regarded as part of the bit interleaver 822, 823, so the DVB-T2 BICM encoder can be considered as having the standard structure shown in Fig. 1.

The LDPC codes used in DVB-T2 are repeat-accumulate quasi-cyclic codes with a cyclic factor Q=360. Two codeword lengths are specified by the standard: 16200 and 64800 bits. These codes will be referred to as the 16K and 64K codes throughout this document. The number of cyclic blocks in a codeword is 45 for the 16K codes and 180 for the 64K codes. The available codes for the two block lengths are listed in tables A.1 through A.6 of the DVB-T2 standard ETSI EN 302.755.

The bit interleaver is used only for constellations larger than QPSK and consists of three sequential steps: parity interleaver 822, column-row interleaver 823, and bit-to-cell demultiplexer 824. The parity interleaver 822 permutes the parity bits so that their quasi-cyclic structure is revealed, as discussed above (see Figs. 4 and 5).

The column-row interleaver 823 works conceptually by writing the bits of the LDPC codeword into an interleaver matrix column-wise and reading them out row-wise. The first bit of the LDPC codeword is written and read out first. After writing the bits and prior to reading them out, the columns are cyclically shifted with a predetermined number of positions, which is referred to as column twisting in the DVB-T2 standard. The number of columns and rows for the two LDPC block lengths and the various constellation sizes are summarized in the following Table 1.

**Table 1:**

| LDPC Size | Modulation | # columns Nc | # rows Nr |
|-----------|-----------|-------------|-----------|
| 16200 | 16QAM | 8 | 2025 |
| | 64QAM | 12 | 1350 |
| | 256QAM | 8 | 2025 |
| 64800 | 16QAM | 8 | 8100 |
| | 64QAM | 12 | 5400 |

(continued)

| LDPC Size | Modulation | # columns Nc | # rows Nr |
|---|---|---|---|
| | 256QAM | 16 | 4050 |

The number of columns (# columns Nc) is twice the number of bits per constellation, except for the case of 16K codes with 256QAM constellations. The reason for this exception is the fact that the LDPC codeword length of 16200 is not a multiple of 16, i.e. twice the number of bits in a 256QAM constellation.

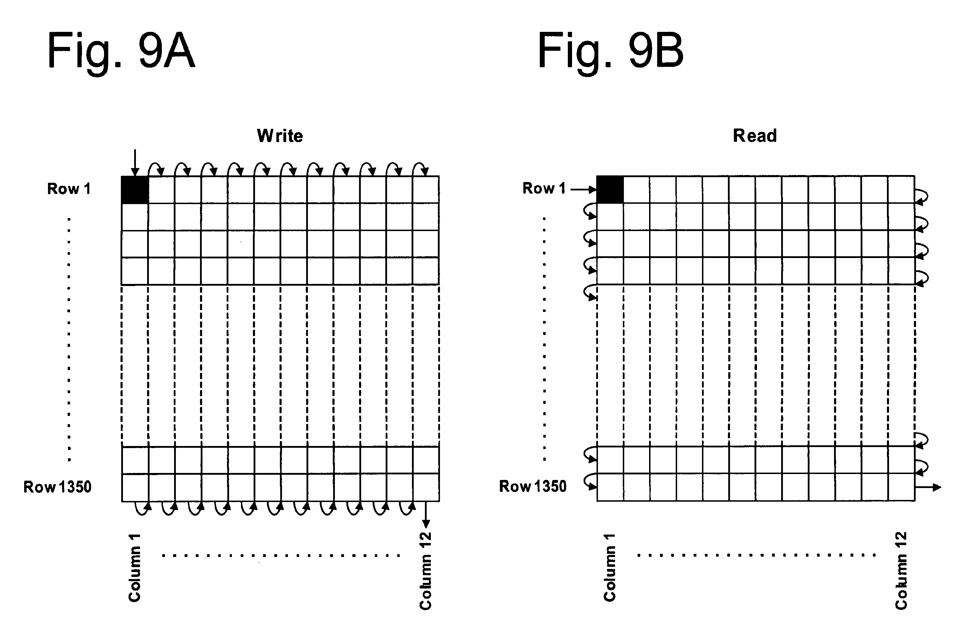

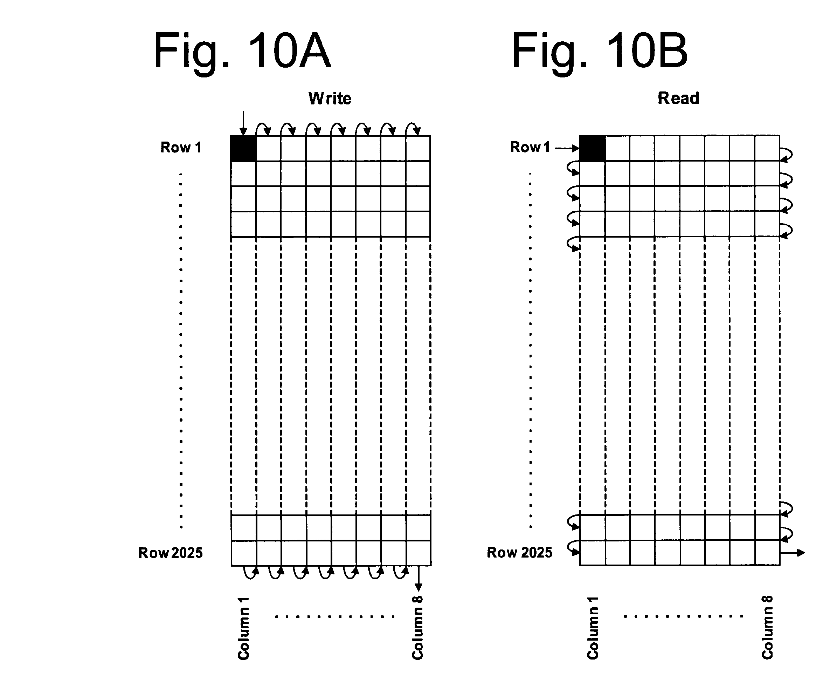

The column-row interleavers 823 for 16K codes are illustrated in Figs. 9 and 10 for the cases of 8 and 12 columns, respectively. Each of the small squares corresponds to one bit of the LDPC codeword; the filled square indicates the first bit of the LDPC codeword. Arrows indicate the sequence in which bits are written to and read from the matrix. Note that the column twisting is not shown in these figures.

Prior to the QAM mapping, each LDPC codeword is first de-multiplexed into multiple parallel bit streams. The number of streams is twice the number of bits encoded in one QAM constellation, i.e. 2xM. The M bits encoded in a constellation are referred to as a cell word. For 16K LDPC codes the resulting number of QAM cells per codeword is therefore 16200/M, as follows:

8100 cells for QPSK,

4050 cells for 16QAM,

2700 cells for 64QAM, and

2025 cells for 256QAM.

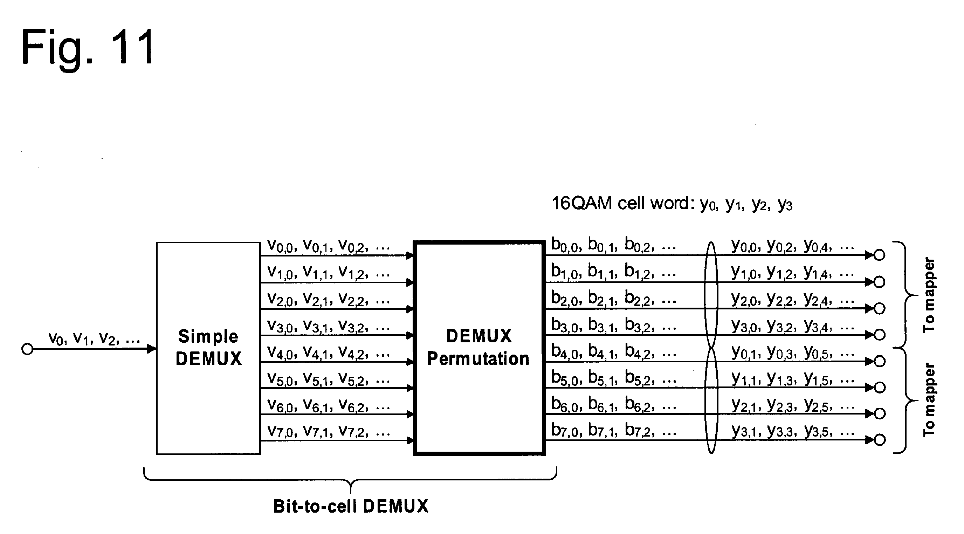

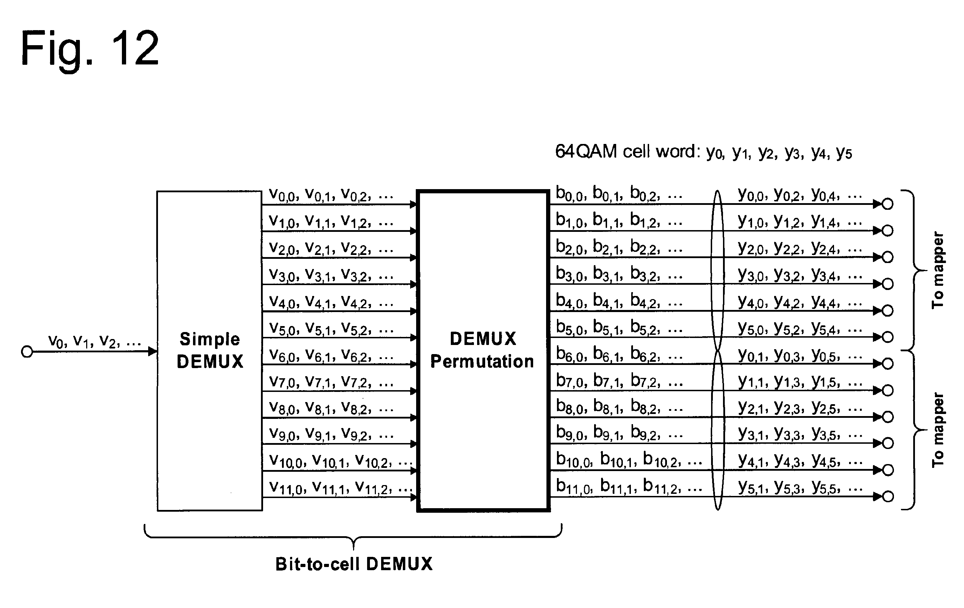

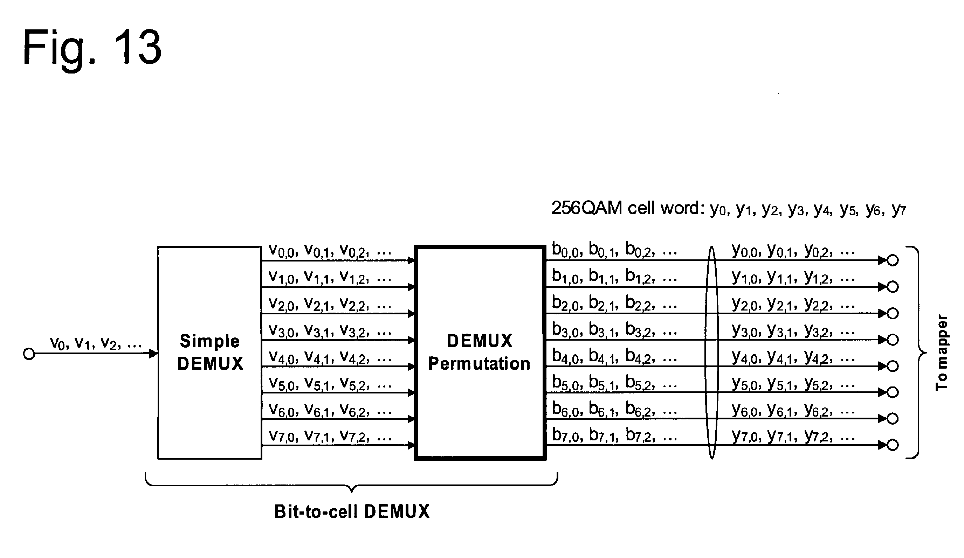

For constellations larger than QPSK, the number of parallel streams is equal to the number of columns in the column-row interleaver, according to the table above. For 16K LDPC codes the bit-to-cell demultiplexers (DEMUX) are shown in Figs. 11, 12, and 13 for 16QAM, 64QAM, and 256QAM constellations, respectively. The notations of the bits are those used in the DVB-T2 standard.

In addition to the mere demultiplexing of the interleaved LDPC codeword, the bit-to-cell demultiplexer also performs an additional permutation of the demultiplexed parallel bitstreams. However, it is important to realize that the permutation of the bitstreams is equivalent to a permutation of the columns of the column-row interleaver since for the cases where a column-row interleaver is used (16QAM constellations and larger) the number of parallel bitstreams is exactly the number of columns in the column-row interleaver. That is why the DEMUX permutation can be regarded as part of the bit interleaver.

There are essentially two problems with the bit interleaver used in DVB-T2.

First, if the number of cyclic blocks in the LDPC codeword is not a multiple of the number of bit-interleaver columns, the parallelism is impaired. The reduced parallelism leads to an increase in latency, which is problematic, especially when iterative BICM decoding is used in the receiver. This situation occurs for several DVB-T2 combinations of LDPC codeword length and constellation size.

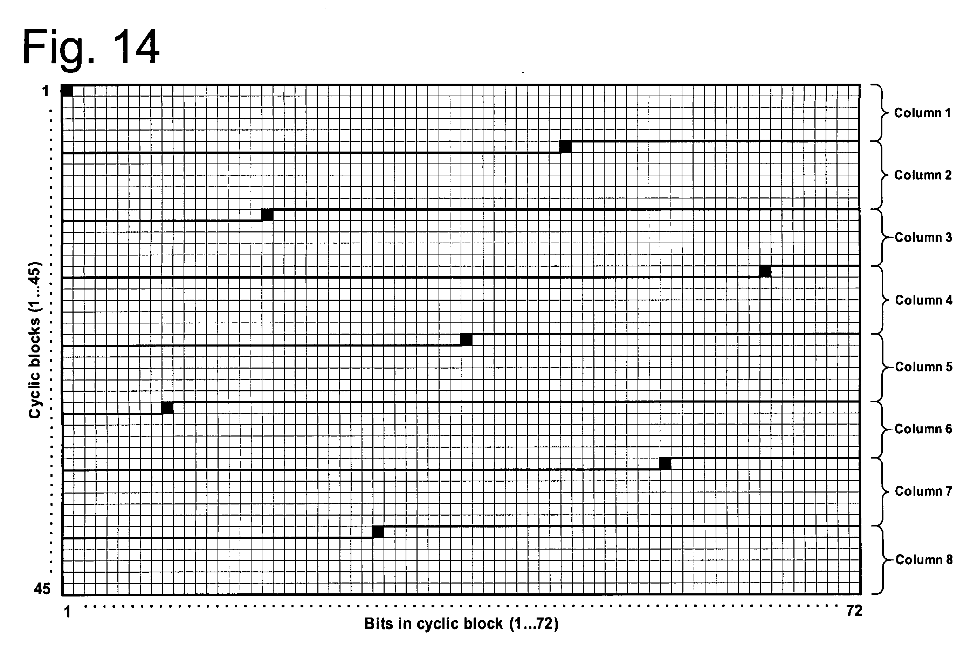

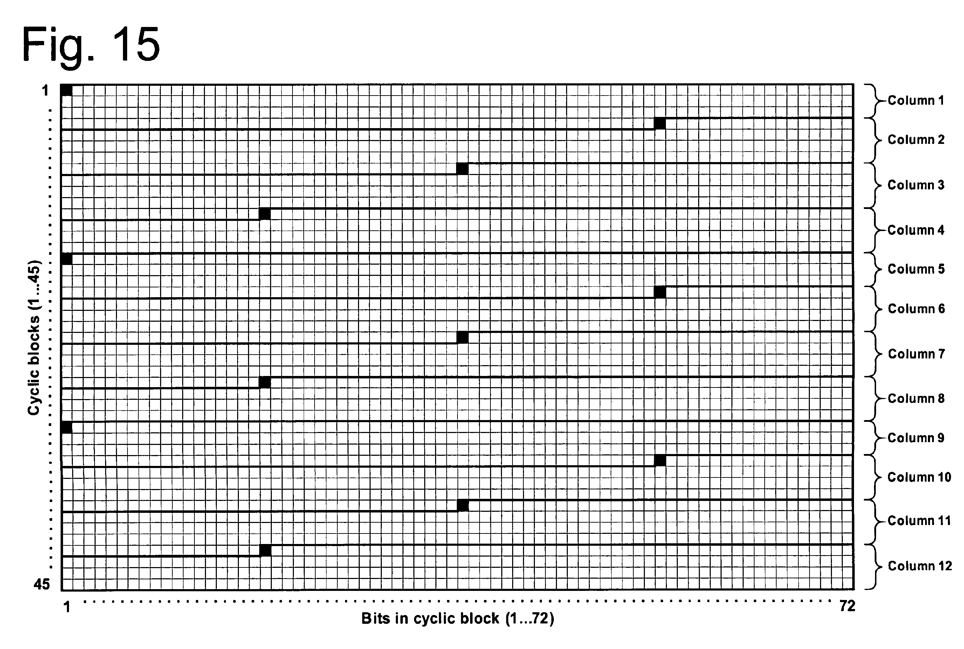

Fig. 14 and Fig. 15 show two such situations for 16K LDPC codes, which occur when the number of columns is 8 and 12 respectively. Eight columns are used with 16QAM and 256QAM constellations, and twelve columns are used with 64QAM constellations. The grid represents an LDPC codeword, the rows corresponding to the cyclic blocks and the columns corresponding to bits of the same index in a cyclic block. The filled squares mark the 8 and 12 bits of the first row in the column-row interleaver matrix. Note that the number of bits per cyclic block has been reduced from 360 to 72 for clarity, but this fact does not affect the understanding.

Second, in DVB-T2 the number of possible bit-interleaver configurations is limited by the number of columns in the bit interleaver.

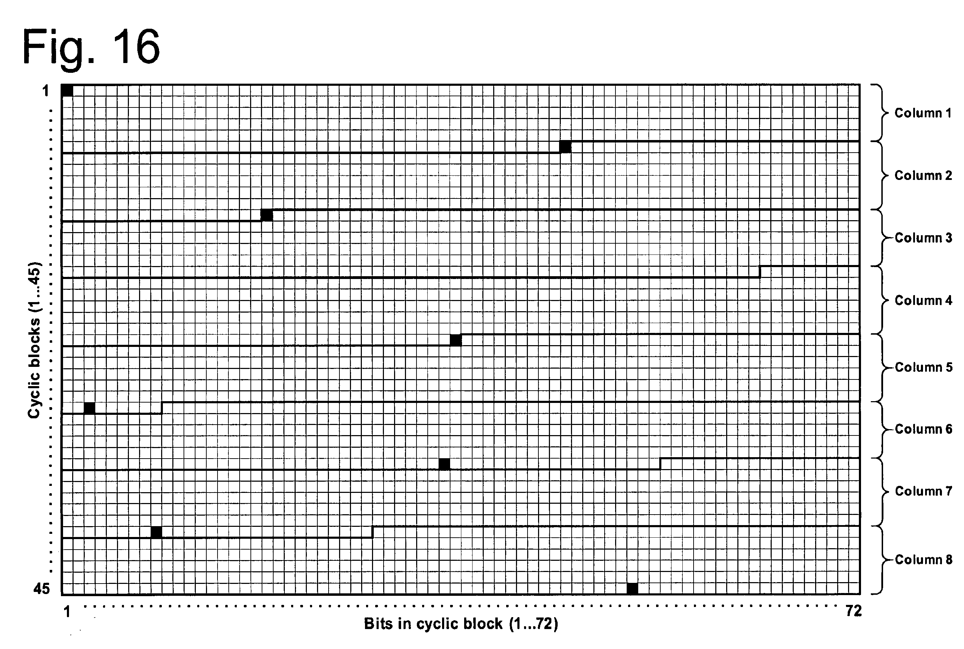

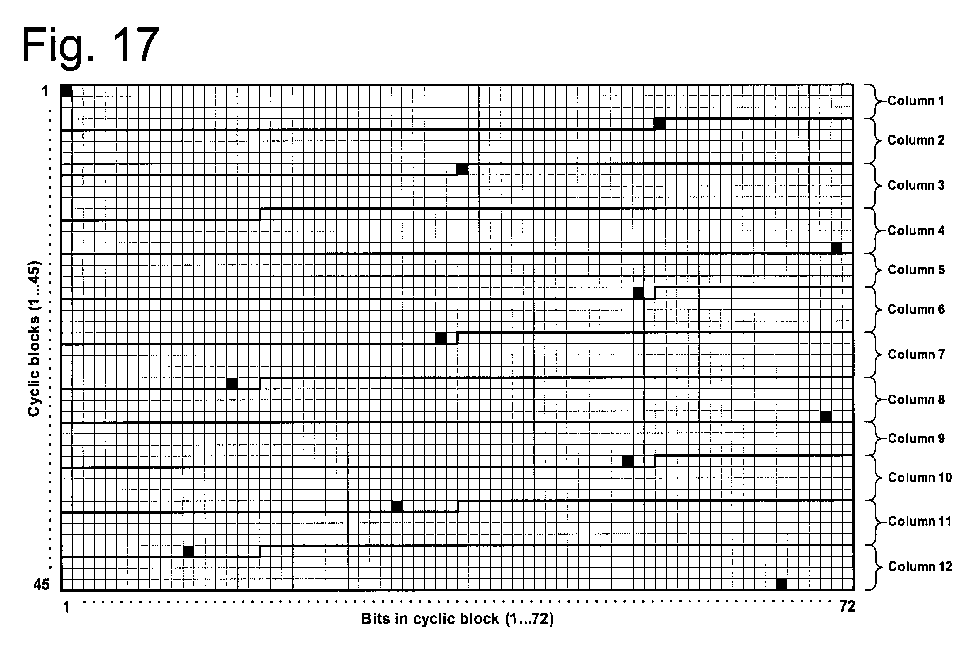

A further problem of the DVB-T2 bit interleaver is that the regularity and the parallelism of the permutation is further impaired by the column twisting. Fig. 16 and Fig. 17 show the same situations as in Fig. 14 and Fig. 15, respectively, but with the column twist enabled. The column twist values used in DVB-T2 for 16K codes and 8 columns are (0, 0, 0, 1, 7, 20, 20, 21) and for 16K codes and 12 columns (0, 0, 0, 2, 2, 2, 3, 3, 3, 6, 7, 7).

Hence, there is a need for an improved bit interleaver which provides a low latency and a high degree of parallelism. These two properties are especially important in iterative BICM decoding.

SUMMARY OF THE INVENTION

It is an object of the present invention to provide a bit interleaver for BICM that is optimized to maximize the parallelism and that enables a high throughput and low latency. It is a further object of the present invention to provide a bit interleaver that offers more freedom in optimizing the mapping of the constellation bits to the LDPC codeword bits than conventional bit interleavers known from the DVB-T2 standard. It is a further object of the present invention to provide a bit interleaver that is specifically optimized for quasi-cyclic LDPC codes.

This is achieved by the features as set forth in the independent claims.

Preferred embodiments are the subject matter of dependent claims.

It is the particular approach of the present invention to divide the cyclic groups of the codeword into a plurality of sections that may be handled independently of each other, such that each $M$-bit constellation word is made up of $F$ bits from each of $F \cdot M$ distinct cyclic blocks of the corresponding section ($F$ is an integer greater than 1).

According to a first aspect of the present invention, a method for bit-interleaving in a communication system with quasi-cyclic low-density parity-check codes is provided. The method comprising the steps of receiving a codeword of the quasi-cyclic low-density parity-check code, the codeword consisting of N cyclic blocks, each cyclic block consisting of Q bits; applying a bit permutation to the bits of the codeword; dividing the permuted codeword into a plurality of constellation words, each constellation word consisting of M bits and indicating one of 2M predefined constellation points, and is characterized by dividing the codeword into F-N/M sections, F being an integer greater than one, each section comprising M/F cyclic blocks, each constellation word being associated with a corresponding one of the sections; and wherein the step of applying the bit permutation is performed by applying, for each section, a section permutation to the M.Q/F bits of the section, the section permutation being adapted such that each constellation word is made up of F bits from each of the M/F cyclic blocks of the corresponding section.

According to a second aspect of the present invention, a bit-interleaver for a communication system with quasi-cyclic low-density parity-check codes is provided. The bit-interleaver comprises a bit permutation unit adapted for receiving a codeword of the quasi-cyclic low-density parity-check code, the codeword consisting of N cyclic blocks, each cyclic block consisting of Q bits, for applying a bit permutation to the bits of the codeword, and for outputting the permuted codeword such that the permuted codeword is divided into a plurality of constellation words, each constellation word consisting of M bits and indicating one of 2M predefined constellation points, and is characterized in that the bit permutation unit comprises a plurality of section permutation units, each of which is adapted for receiving the bits of M/F cyclic blocks, F being an integer greater than one, for applying a section permutation to the received bits, and for outputting the permuted bits such that each constellation word is made up of F bits from each of M/F distinct cyclic blocks, wherein each constellation word is associated with a corresponding one of the section permutation units such that all bits of the constellation word are output by the corresponding section permutation unit only.

In a preferred embodiment, the section permutation is adapted such that all bits of a given cyclic block are mapped to constellation word bits that have the same robustness level within the given set of predefined constellation points. In this manner, codeword bits having the same importance are mapped to constellation bits having the same robustness. This is clearly advantageous, because the importance and the robustness may be matched. For example, the most important codeword bits may be mapped to the most robust constellation bits, and the least important codeword bits may be mapped to the least robust constellation bits, and so forth.

Preferably, F is equal to the number of constellation word bits that have the same robustness level within the given set of predefined constellation points. This is situation is referred to as maximum folding and allows for the most efficient hardware implementation.

In a particularly important application example, F=2 and the predefined constellation points represent a QAM constellation.

Preferably, the step of applying the section permutation comprises applying a column-row permutation on the M-Q/F bits of the section. Here, a column-row permutation is a permutation equivalent to writing the M.Q/F bits column-wise into a matrix of Q columns and M/F rows and reading out the permuted bits row-wise.

According to a third aspect of the present invention, a method for deinterleaving a bitstream in a communication system with quasi-cyclic low-density parity-check codes is provided. The method comprises the steps of receiving a bit string consisting of N·Q bits; and applying an inverse bit permutation to the received bit string in order to recover a codeword of the quasi-cyclic low-density parity-check code, the inverse bit permutation being adapted for reverting the permutations performed by the bit-interleaving method according to the first aspect of the present invention.

According to a fourth aspect of the present invention, a deinterleaver for deinterleaving a bitstream in a communication system with quasi-cyclic low-density parity-check codes is provided. The deinterleaver comprises an an inverse bit permutation unit adapted for receiving a bit string consisting of N·Q bits, and for applying an inverse bit permutation to the received bit string in order to recover a codeword of the quasi-cyclic low-density parity-check code, the inverse bit permutation being adapted for reverting the bit permutations performed by the bit interleaver according to the second aspect of the present invention.

According to a fifth aspect of the present invention, a decoder for a bit-interleaved coding and modulation systems with quasi-cyclic low-density parity-check codes is provided. The decoder comprises a constellation demapper for generating a sequence of soft-bits indicating a probability of the corresponding bit being 0 or 1; a deinterleaver according to the fourth aspect of the present invention for deinterleaving the sequence of soft-bits; and a low-density parity-check decoder for decoding the deinterleaved sequence of soft-bits.

Preferably, the decoder further comprises a subtractor for subtracting the input and the output of the low-density parity-check decoder; and an interleaver according to the second aspect of the present invention for feeding the difference between the input and the output of the low-density parity-check decoder back to the constellation demapper. In this manner, the sequence of soft-bits may be decoded in an iterative manner.

The above and other objects and features of the present invention will become more apparent from the following description and preferred embodiments given in conjunction with the accompanying drawings, in which:

Fig. 1        is a block diagram of a transmitter-side communication chain involving a BICM encoder;

Fig. 2        illustrates an exemplary parity-check matrix of a QC LDPC code of rate 1/2;

Fig. 3        illustrates an exemplary parity-check matrix of an RA QC LDPC code of rate 2/3;

Fig. 4        illustrates the parity-check matrix of the RA QC LDPC code of Fig. 3 after row permutation;

Fig. 5        illustrates the parity-check matrix of the RA QC LDPC code of Fig. 3 after row permutation and parity permutation;

Fig. 6        illustrates the different robustness levels of the bits encoded in an 8PAM symbol;

Fig. 7        is a block diagram of a generic bit interleaver for Q=5, N=12, M=4;

Fig. 8A       is a schematic system overview of a DVB-T2 modulator;

Fig. 8B       is a block diagram of an BICM encoder as used in DVB-T2;

Fig. 9A       illustrates the writing process of a column-row interleaver for 16K codes with 8 columns;

Fig. 9B       illustrates the reading process of the column-row interleaver of Fig. 9A;

Fig. 10A      illustrates the writing process of a column-row interleaver for 16K codes with 12 columns;

Fig. 10B      illustrates the reading process of the column-row interleaver of Fig. 10A;

Fig. 11       illustrates the bit-to-cell demultiplexers for 16QAM and 16K LDPC codes according to the DVB-T2 standard;

Fig. 12       illustrates the bit-to-cell demultiplexers for 64QAM and 16K LDPC codes according to the DVB-T2 standard;

Fig. 13       illustrates the bit-to-cell demultiplexers for 256QAM and 16K LDPC codes according to the DVB-T2 standard;

Fig. 14       illustrates the DVB-T2 bit interleaver with 8 columns for 16K LDPC codes;

Fig. 15       illustrates the DVB-T2 bit interleaver with 12 columns for 16K LDPC codes;

Fig. 16       illustrates the DVB-T2 bit interleaver with 8 columns for 16K LDPC codes with column twist;

Fig. 17       illustrates the DVB-T2 bit interleaver with 12 columns for 16K LDPC codes with column twist;

Fig. 18       is a functional representation of the interleaver sections according to the present invention;

Fig. 19       is a structural representation of the interleaver sections according to the present invention;

Fig. 20A      is a structural representation of the section permutation according to a preferred embodiment of the present invention;

Fig. 20B     is a functional representation of the section permutation according to a preferred embodiment of the present invention;

Fig. 20C     is a functional representation of the column-row section permutation of Fig. 20A;

Fig. 21     is a structural representation of a parallel bit interleaver with additional cyclic-group permutation according to a preferred embodiment of the present invention;

Fig. 22     is a structural representation of a parallel bit interleaver with three permutation steps according to another preferred embodiment of the present invention;

Fig. 23A     is a block diagram of a receiver with a non-iterative BICM decoder;

Fig. 23B     is a block diagram of a receiver with an iterative BICM decoder;

Fig. 24     is a more detailed block diagram of a receiver with an iterative BICM decoder;

Fig. 25     is an illustration of the interleaver sections and the excluded cyclic block in accordance with an embodiment of the present invention;

Fig. 26A     is a functional representation of the permutation without folding;

Fig. 26B     is a functional representation of the permutation with folding;

Fig. 27A     is a structural representation of the permutation of Fig. 26A without folding;

Fig. 27B     is a structural representation of the permutation of Fig. 26B with folding;

Fig. 28     is a block diagram of a parallel interleaver with 2x folding according to a preferred embodiment of the present invention;

Fig. 29     is a schematic illustration of the LLR memory locations and the bits of the first constellation for 2x folding; and

Fig. 30     is a schematic illustration of the mapping of constellation blocks with hybrid QPSK+16QAM constellations.

DETAILED DESCRIPTION

The present invention provides a bit interleaver and deinterleaver which lend themselves to a high degree of parallelization, and corresponding methods, as well as a BICM encoder and BICM decoder with such a (de-)interleaver.
The inventor has realized that a highly efficient interleaver can be provided if the following two conditions are fulfilled:

1. The M bits of each constellation are mapped to M distinct cyclic blocks of the LDPC codeword.

2. All constellations that are mapped to said M cyclic blocks are mapped to those cyclic blocks only.

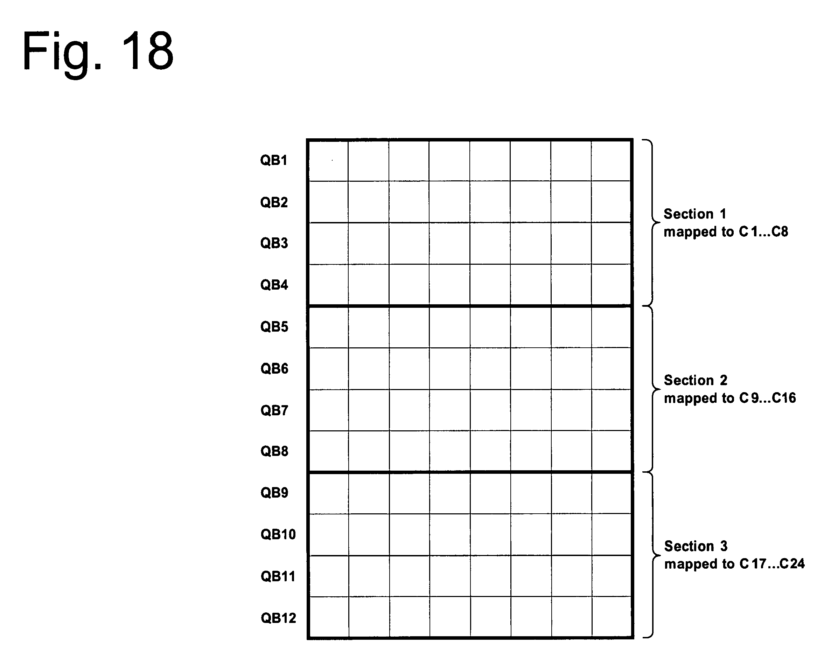

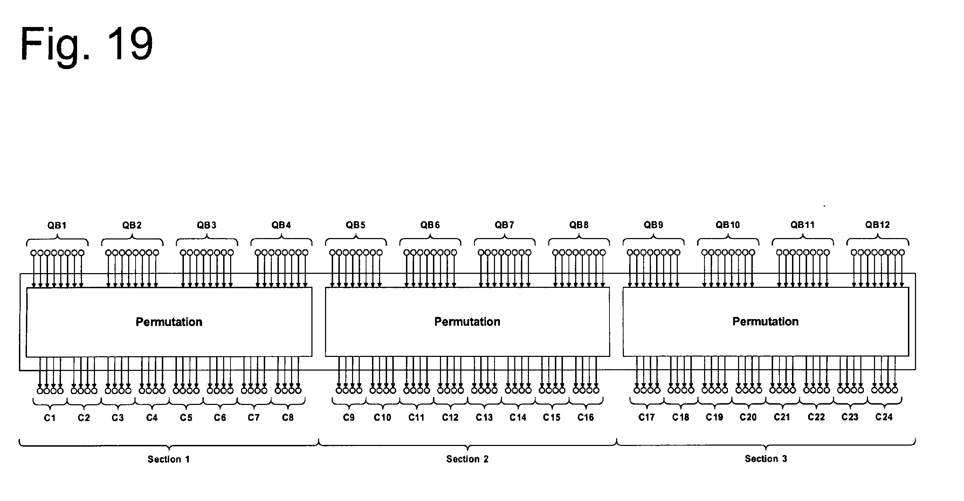

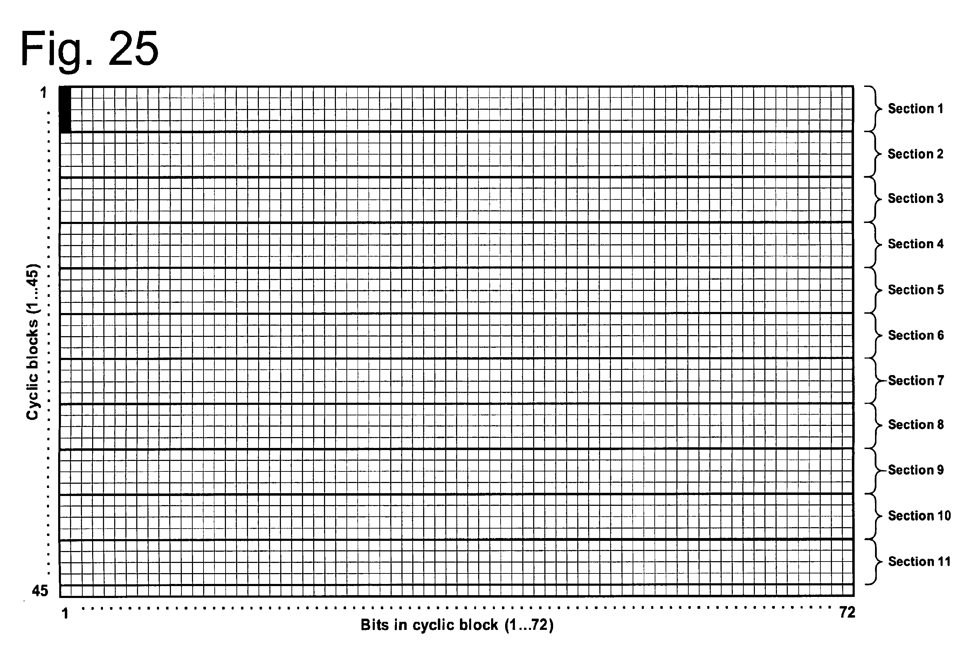

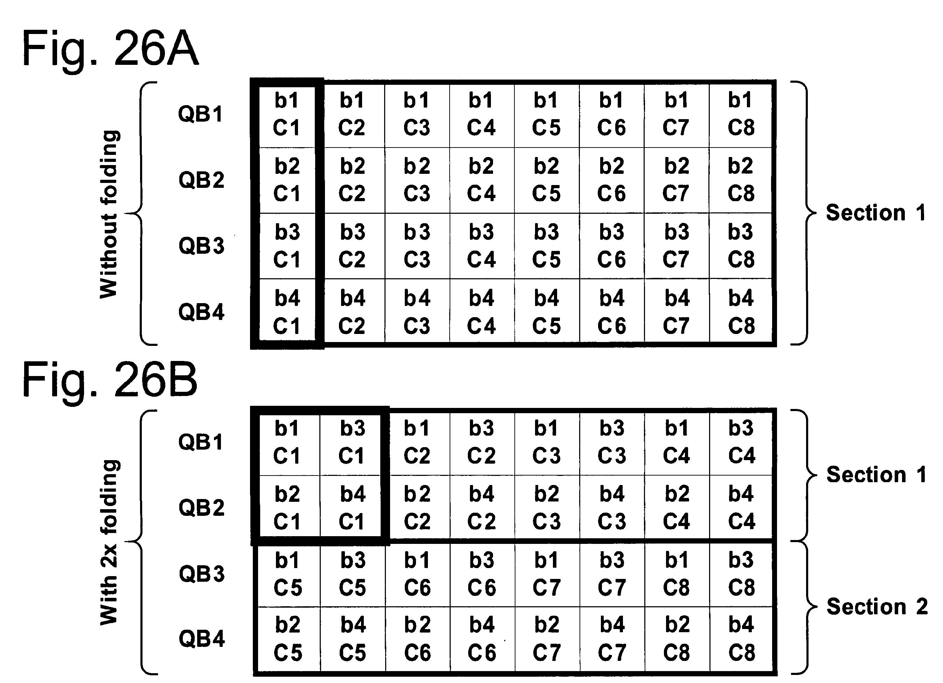

A corollary of the above is that exactly Q constellations are mapped to each M cyclic blocks. This is illustrated in in Figs. 18 and 19 for the chosen example with Q=8, M=4, and N=12. Each group of M cyclic blocks or Q constellations is referred to as an interleaver section. The number of parallel sections per LDPC codeword is N/M. Obviously, such a parallelization is only possible if $N$ is a multiple of $M$.
In the following, the general concept of present invention will be explained first under the premise that the above condition is met. Modifications and extensions that are necessary for applying the invention also to a situation where $N$ is not a multiple of $M$ will be explained thereafter in connection with Fig. 25. Preferred embodiments of the present invention, in particular with respect to a relaxed version of the first condition mentioned above, will be explained in connection with Figs. 26 to 30.

General Concept of a Parallel Bit Interleaver

The two conditions mentioned above only ensure that the interleaver can be separated into $N/M$ parallel sections. Each of these parallel sections may have a different permutation.

Advantageously, the section permutation maps the Q bits of a cyclic block, which have the same importance in the LDPC decoding, to bits with the same index in their respective constellations, which have the same robustness. For each cyclic block the Q bits can be in sequential or permuted order.

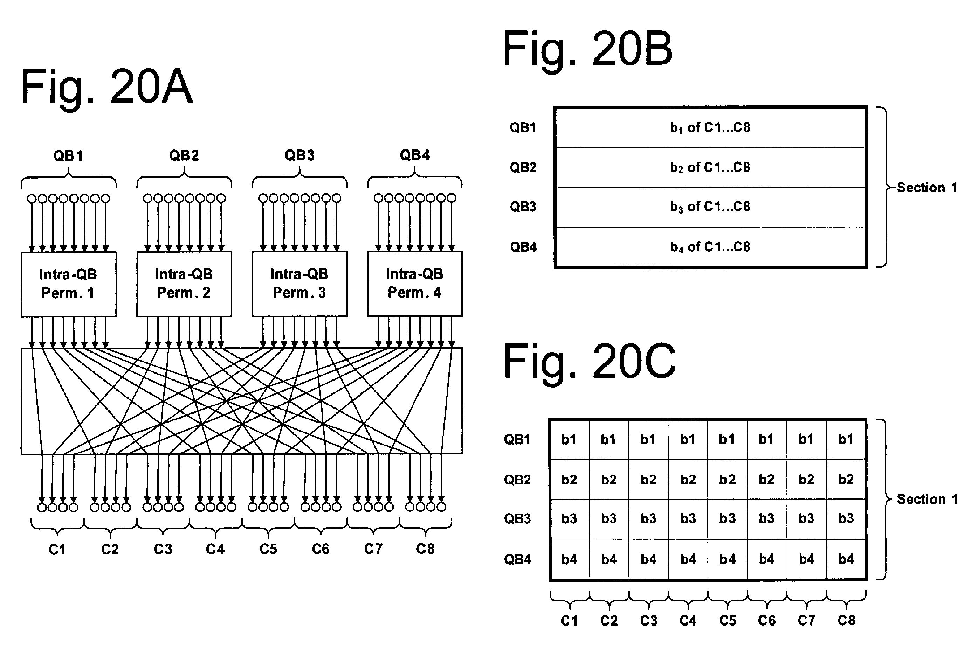

Fig. 20A shows a structural representation of the section permutation, which consists of two concatenated permutations: an intra-cyclic-group permutation, which can be different for each cyclic group, and a column-row permutation. The latter can be conceptually realized by writing the LDPC bits column-wise into a matrix with M columns and Q rows and reading them out row-wise. Fig. 20B shows the functional representation of the mapping, where the $M$=4 bits of each constellation are denoted by b1 through b4.

The intra-cyclic-group permutation, however, is not essential. An example implementation without intra-cyclic-block permutations, i.e. when the bits are mapped in sequential order, is shown in Fig. 20C. In this case, the section permutation is just a column-row permutation.

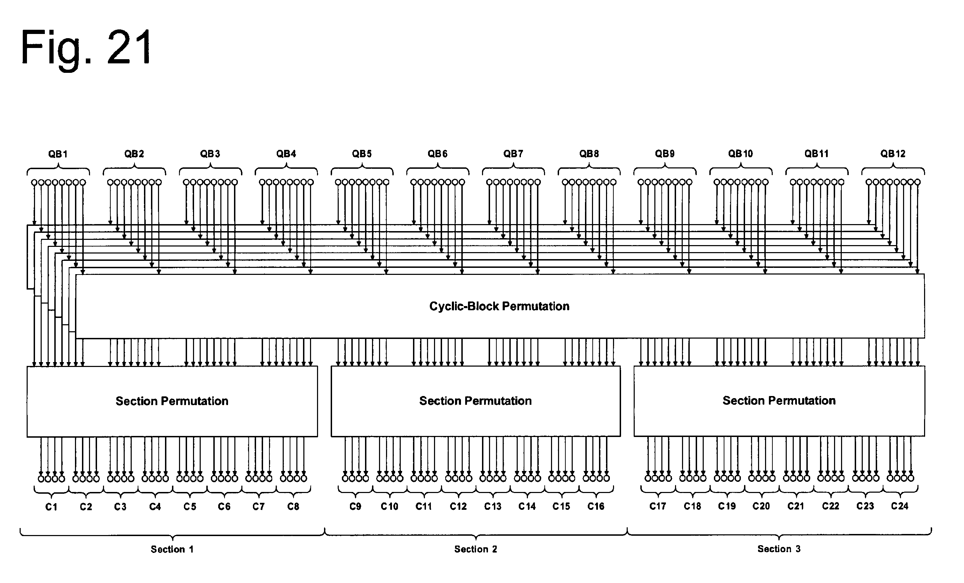

Advantageously, an additional permutation of the $N$ cyclic groups may be performed before applying the section permutations. Application of the additional cyclic-group permutation is shown in Fig. 21. In this context, it is also noted that he cyclic-group permutation plays a role similar to that of the permutation in the bit-to-cell demultiplexer in the DVB-T2 standard.

The additional permutation of the $N$ cyclic groups is particularly advantageous as it enables the optimized mapping of the LDPC codeword bits onto the constellation bits, resulting in an optimized performance.

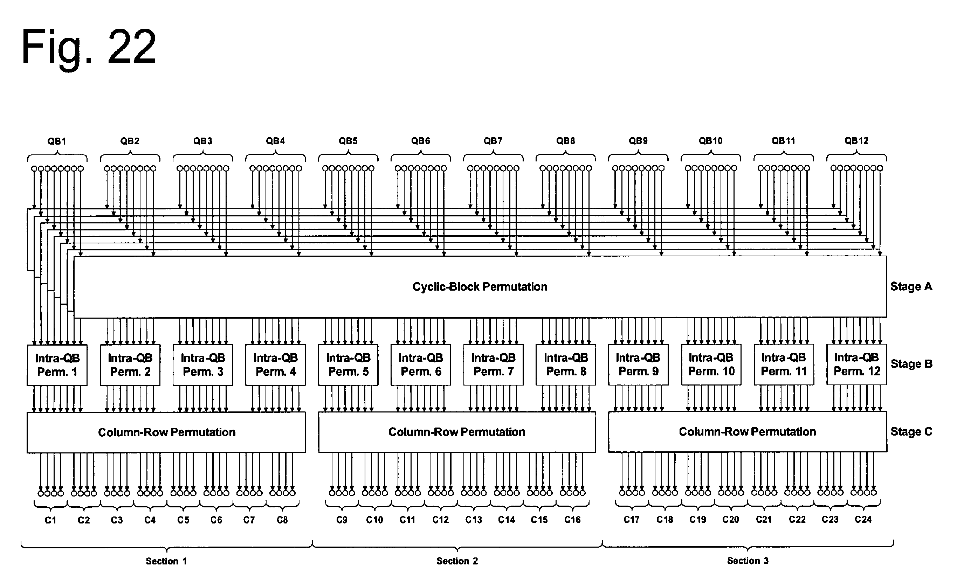

Figure 22 is another representation of the inventive bit interleaver. The bit interleaver comprises three stages, namely

- Stage A: (inter) cyclic-group permutation: Q identical N-bit permutations

- Stage B: intra-cyclic-group permutation: $N$ usually different Q-bit permutations

- Stage C: column-row permutation: $N/M$ identical permutations

The intra-cyclic-group permutation is optional and can also be performed before the cyclic-group permutation.

Advantageously, the intra-cyclic group permutations may have similar structures, so that they can be implemented with identical functional resources, e.g. hardware blocks. Preferably, they may consist of cyclic shifts, which allow for an efficient hardware implementation using barrel shifters. In some implementations, the barrel shifter used in the LDPC decoder can be reused.

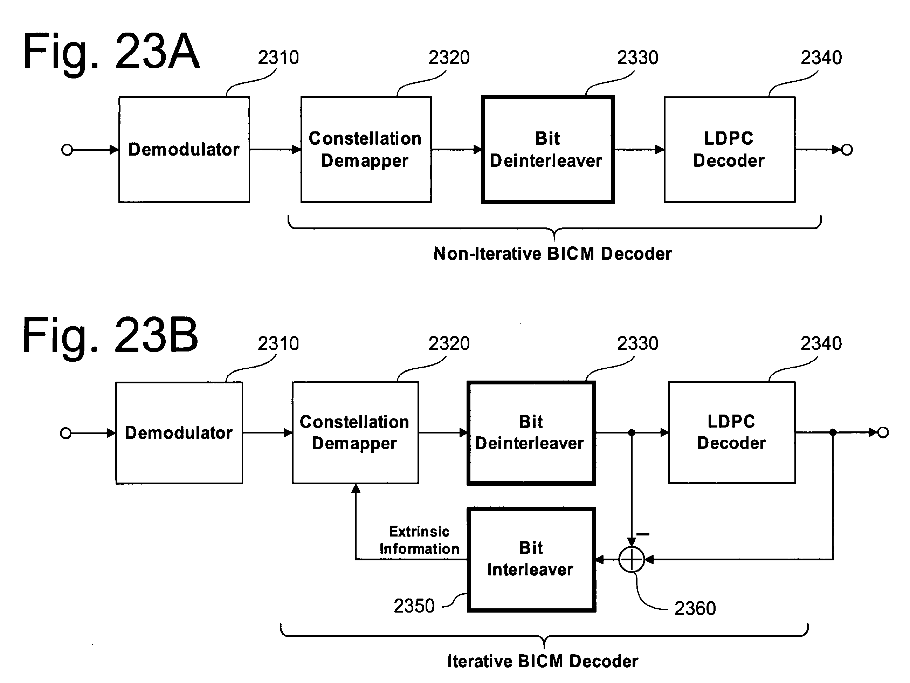

Figs. 23A and B are block diagrams of a receiver with a non-iterative and an iterative BICM decoder, respectively. The receiver performs the reverse operations of the transmitter, that is, demodulation 2310 such as OFDM, followed by BICM decoding. The latter in turn consists of constellation demapping 2320, bit deinterleaving 2330, and LDPC decoding 2340, as shown in Fig. 23A. The constellation demapper 2320 generates so-called soft bits, which are a measure of the probability of the bits to be 0 or 1. Typically the soft bits are represented as log-likelihood ratios (LLRs), which are defined as

$$\text{LLR}(b) = \ln [\text{p}(b{=}0) \,/\, \text{p}(b{=}1)];$$

where p($b$=0) is the probability that the bit $b$ is 0 and p($b$=1) is the probability that the bit $b$ is 1. Of course, p($b$=0) + p($b$=1) = 1.

An improved technique, which offers significant performance gains, is the iterative BICM decoding. The structure of an iterative BICM decoder is shown in Fig. 23B. After one or more LDPC decoding iterations, the extrinsic information obtained by subtracting the input and the output of the LDPC decoder 2340 by subtractor 2360 is fed back to the constellation demapper 2320 via bit interleaver 2350. The constellation demapper 2320 uses the new extrinsic information as a-priori information to compute more reliable LLR values, which are deinterleaved and used in a new LDPC decoding step.

As shown in Fig. 23B, the iterative decoding loop consists of the following four elements: constellation demapper 2320, bit deinterleaver 2330, LDPC decoder 2340, and bit interleaver 2350. In order to enable an efficient receiver implementation, the (de)interleaver should have very low latency, ideally zero, and low complexity. The bit interleaver provided by the present invention satisfies both these conditions.

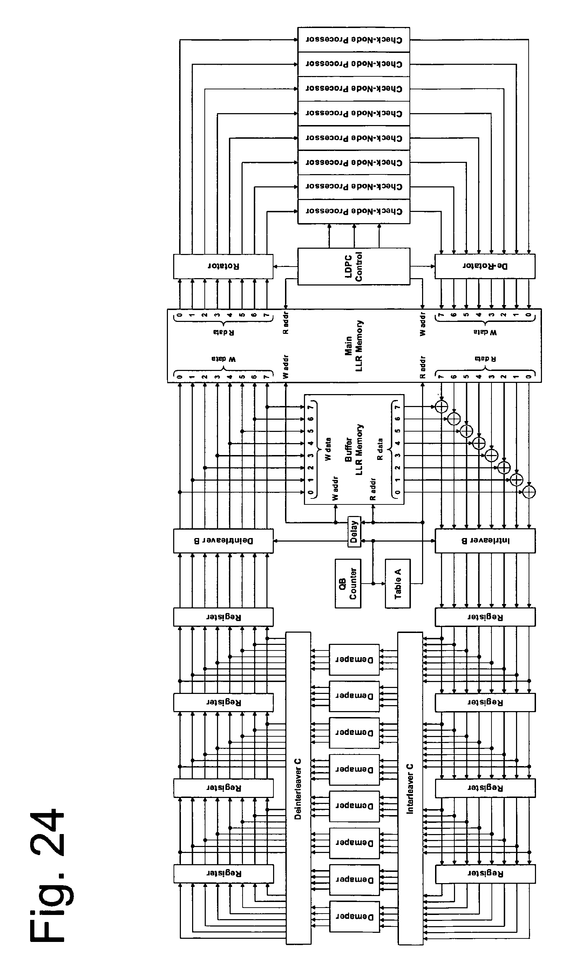

Referring now to Fig. 24, a detailed structure of an iterative BICM decoder is described in order to show how the invention allows for a very efficient parallel implementation. A specific embodiment of such an iterative BICM decoder is shown in Fig. 24 for a cyclic factor Q=8 and a constellation size M=4.

The main LLR memory stores the LLR values after deinterleaving and is also used by the LDPC decoder. The LDPC decoding is an iterative process consisting of one or more iterations. In each LDPC decoding iteration the LLR values in the main LLR memory are updated. In order to compute the extrinsic information needed for iterative BICM decoding, the old LLR values are saved in a buffer LLR memory. After a predefined number of LDPC iterations, a BICM iteration is performed. The LDPC and BICM iterations are also referred to as inner and outer iterations respectively. In some implementations it is also possible to overlap the two kinds of iterations, which can increase the speed of the convergence process. The BICM and LDPC decoding are well known in the art and, hence, will not be described in any further detail.

Each of the Q demappers receives M interleaved extrinsic LLR values and produces M updated LLR values, which are interleaved and written back into the main LLR memory and the buffer LLR memory. Although the embodiment in Fig. 24 contains Q demappers working in parallel, it is possible to implement iterative BICM decoder with a lower or a higher degree of parallelism. It is for example straightforward to see that the parallelism can be easily increased by the number of parallel sections in the bit interleaver, i.e. N/M. Such an approach maximizes the parallelism by employing QN/M demappers in parallel. The disclosed bit interleaver has the merit of allowing for such a high degree of parallelism without any bottlenecks.

The table A and the interleavers B and C in Fig. 24 correspond exactly to the permutation stages A, B, C in Fig. 22. Table A is a simple look-up table that stores the cyclic block permutation. The cyclic blocks are read from and written into the LLR memory in the order specified by the cyclic-block permutation. Interleaver B is configurable and has a certain hardware cost, which can be, however, minimized by careful design. Interleaver C implements a column-row permutation, which is fixed for a given constellation size and thus has negligible implementation costs.

<u>Generalization to N being not a multiple of M</u>

As already mentioned above, the number of bits per constellation *M* must be a divisor of the number of cyclic groups *N*. In some cases, however, that's not possible. Such a case is the 16K LDPC code used in DVB-T2, which has 45 cyclic groups. The mapping of square constellations such as QAM, which have an even number of bits, is not straightforward.

Therefore, it is the particular approach of the present invention to exclude one or more cyclic blocks and to apply the parallel interleaver to the remaining cyclic blocks only. In other words, a subset of the *N* cyclic blocks is selected such that the number of selected cyclic blocks is a multiple of the number of bits per constellation word. The selected subset of cyclic blocks is the divided into a plurality of sections, each section comprising *M* cyclic blocks, which are then treated as explained above.

Specifically, a method for bit-interleaving in a communication system with quasi-cyclic low-density parity-check codes may comprise the steps of receiving a codeword of the quasi-cyclic low-density parity-check code, the codeword consisting of N cyclic blocks, each cyclic block consisting of Q bits; applying a bit permutation to the bits of the codeword; dividing the permuted codeword into a plurality of constellation words, each constellation word consisting of M bits and indicating one of 2M predefined constellation points; selecting a subset of the N cyclic blocks such that the number of selected cyclic blocks divided by the number of bits per constellation word yields an integer value; dividing the selected subset of cyclic blocks into a plurality of sections, each section comprising M cyclic blocks, each constellation word of the selected cyclic blocks being associated with a corresponding one of the sections; and wherein the step of applying the bit permutation is performed by applying, for each section, a section permutation to the M·Q bits of the section, the section permutation being adapted such that each constellation word is made up of M bits from M distinct cyclic blocks of the corresponding section.

Similarly, a bit interleaver for a communication system with quasi-cyclic low-density parity-check codes may comprise a bit permutation unit adapted for receiving a codeword of the quasi-cyclic low-density parity-check code, the codeword consisting of N cyclic blocks, each cyclic block consisting of Q bits, for applying a bit permutation to the bits of the codeword, and for outputting the permuted codeword such that the permuted codeword is divided into a plurality of constellation words, each constellation word consisting of M bits and indicating one of 2M predefined constellation points, wherein the bit permutation unit is further adapted for selecting a subset of the N cyclic blocks such that the number of selected cyclic blocks divided by the number of bits per constellation word yields an integer value, and for dividing the selected subset of cyclic blocks into a plurality of sections, each section comprising M cyclic blocks, each constellation word of the selected cyclic blocks being associated with a corresponding one of the sections. The bit interleaver further comprises a plurality of section permutation units, each section permutation unit being adapted for receiving the M·Q bits of one of the plurality of sections, and for applying a section permutation to the received bits, the section permutation being adapted such that each constellation word is made up of M bits from M distinct cyclic blocks of the corresponding section.

Codeword bits that are not part of the selected subset of cyclic blocks, i.e., the bits of the excluded (unselected) cyclic blocks, may remain unpermuted or may be subjected to a separate bit permutation that is applied to the bits of the unselected cyclic blocks only. Preferably, the number of selected cyclic blocks is the greatest integer smaller than N/M. In this manner, bit interleaving can be maximized.

Preferably, the excluded cyclic blocks should be those whose variable nodes have the lowest weight. In the case of repeat-accumulate QC LDPC codes (as in Fig. 5) these cyclic blocks are those from the parity section (with variable nodes of weight 2), preferably the last one or more blocks from the end of the codeword.

Moreover, the selecting step may be adapted for selecting the cyclic blocks on the basis of an importance level of the bits contained therein. The importance level of a bit may be indicated by the number of parity checks the bit is involved in. In the specific case of a repeat-accumulate quasi-cyclic low-density parity-check code, the unselected cyclic blocks may correspond to the parity section of the codeword. In this manner, the most relevant bits the codeword will be subjected to an optimum interleaving. Omitting only less relevant bits from the interleaving process has a marginal effect on the overall efficiency.

Further, the selected cyclic blocks may form a contiguous sub-block of the codeword starting with the first bit of the codeword. In this manner, hardware implementation can be further simplified. Moreover, in the case of a repeat-accumulate quasi-cyclic low-density parity-check code, the last bits of the codeword represent the least relevant bits anyway.

Fig. 25 shows an examplary application of the present invention to the 16K LDPC code according to DVB-T2 with 16QAM constellation. There is one excluded cyclic block in this case (last row in Fig. 25). The dark squares represent the four bits of the first constellation block.

In general, the number of sections is floor($N/M$) and the number of excluded cyclic groups is rem($N,M$). Table 2 below summarizes these values for the 16K LDPC codes in DVB-T2, which have $N=45$, and various constellation sizes.

**Table 2:**

| Constellation | $M$ | # sections | # excluded cyclic blocks |
|---|---|---|---|
| QPSK | 2 | 22 | 1 |
| 16QAM | 4 | 11 | 1 |
| 64QAM | 6 | 7 | 3 |
| 256QAM | 8 | 5 | 5 |

Optimization for Large Constellations

According to the general concept explained above, each constellation is mapped onto M cyclic blocks. For large constellations, however, this approach requires too many delay registers (see the iterative demapper structure illustrated in Fig. 24). This is undesirable since it increases the area and the power consumption. In addition, reducing the number of cyclic blocks that a constellation is mapped onto is beneficial for increasing the overlapping between the outer (BICM) and the inner (LDPC) iterations, which reduces the overall BICM decoding latency.

According to the present invention, the number of cyclic blocks that a constellation is mapped onto may be reduced by mapping more than one bit of each constellation onto the same cyclic block. The number of bits mapped to the same cyclic block is referred to as "folding factor" and denoted by $F$. For example, a 16QAM constellation can be mapped onto only 2 cyclic blocks instead of 4. The only constraint is that the folding factor F, which is an integer greater than 1, must be a divisor of M and Q.

Complex QAM constellation can be naturally decomposed into two identical real PAM (pulse-amplitude modulation) symbols. Therefore, the $M$ bits of a QAM constellation can be divided into two identical sets of $M/2$ bits each, which can be mapped onto the same $M/2$ cyclic blocks. A folding factor of 2 is advantageous for QAM constellations.

Complex constellations that do not have a real decomposition, such as 8PSK, 16APSK, or 32APSK, as used e.g. in the DVB-S2 standard, do not have such a straightforward folding option. However, folding is still possible, provided that the folding factor is a divisor of the number of bits per constellation, but it is no longer possible to ensure that each cyclic block has only bits of the same robustness mapped onto it.

Preferably, the folding strategy must ensure that each cyclic block has only constellation bits of the same robustness mapped onto it.

Folding has the additional benefit of reducing the number of excluded cyclic blocks or rendering them completely unnecessary. As explained above, cyclic blocks need to be excluded from interleaving when $M$ is not a multiple of $N$.

Without folding, the number of sections is floor($N/M$) and the number of excluded cyclic groups is rem($N,M$). With folding, the number of sections is floor($FN/M$) and the number of excluded cyclic groups is rem($N,M/F$). A relevant example are the LDPC codes used in the DVB-T2 standard, as shown in the Table 3.

**Table 3:**

| LDPC Code | Constellation | M | Without folding | | With folding | |
| | | | # sections | # excluded cyclic blocks | # sections | # excluded cyclic blocks |
|---|---|---|---|---|---|---|
| 16K | QPSK | 2 | 22 | 1 | 44 | 1 |
| (N=45, Q=360) | 16QAM | 4 | 11 | 1 | 22 | 1 |
| | 64QAM | 6 | 7 | 3 | 15 | 0 |
| | 256QAM | 8 | 5 | 5 | 11 | 1 |
| 64K | QPSK | 2 | 90 | 0 | 180 | 0 |
| (N=180, Q=360) | 16QAM | 4 | 45 | 0 | 90 | 0 |
| | 64QAM | 6 | 30 | 0 | 60 | 0 |
| | 256QAM | 8 | 22 | 4 | 45 | 0 |

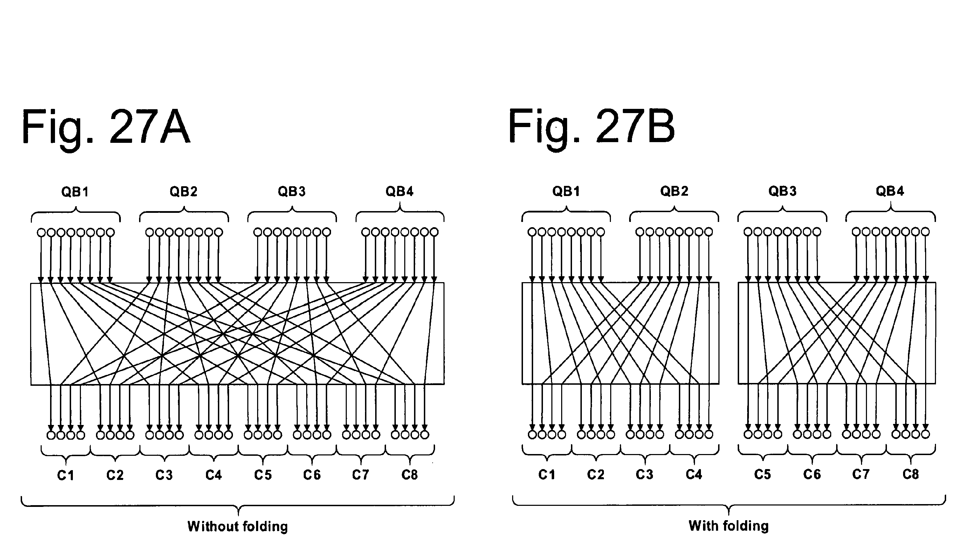

The functional and structural representation of the folding for the chosen example with M=4 and Q=8 and a folding factor F=2 is shown in Figs. 26A-B and Figs. 27A-B, respectively. The structural representation shows the column-row section permutation with and without folding.

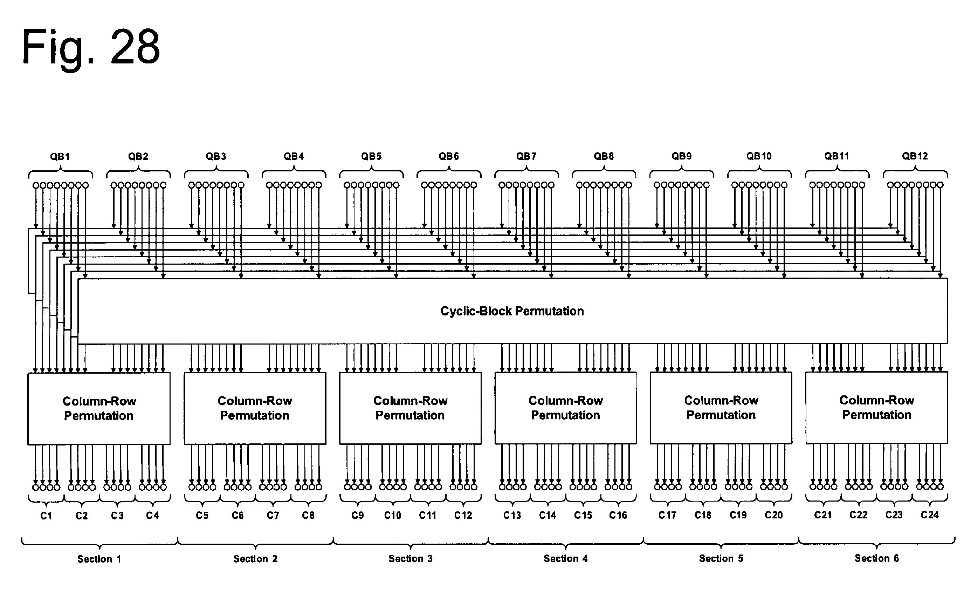

The folding results naturally by reducing the number of cyclic blocks onto which a constellation is mapped by the folding factor $F$. The number of rows in the column-row section permutation is reduced from $M$ to $M/F$. Fig. 28 shows the same interleaver structure as in Fig. 22, but updated for a folding factor $F$=2 and without intra-cyclic-group permutations.

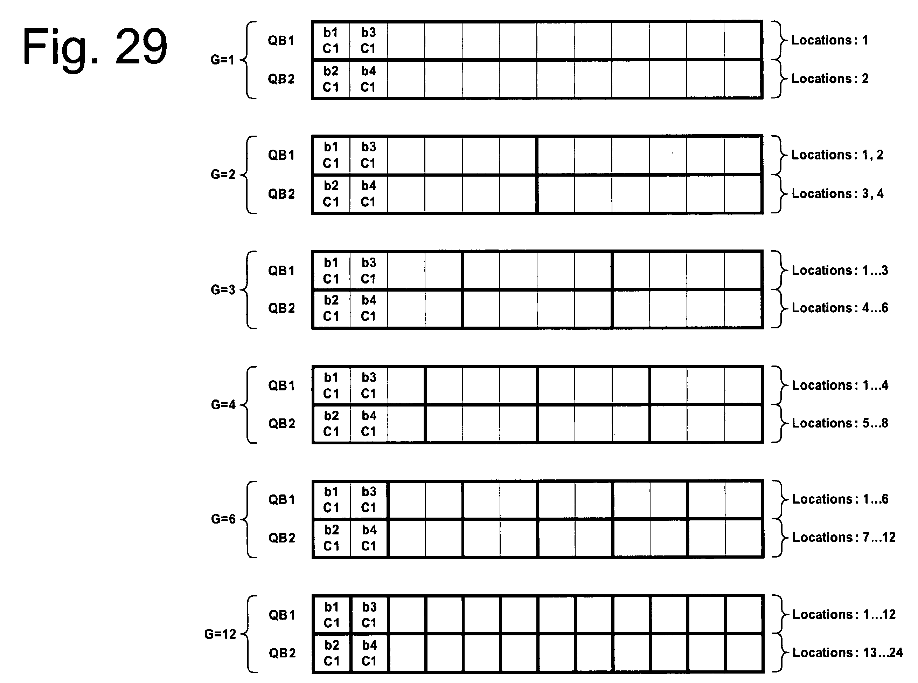

From a hardware implementation point of view, folding is desirable since it allows the bits of a constellation to be located in fewer LLR memory locations. The LLR memory in the decoder (see Fig. 24) typically consists of $G \cdot N$ addressable memory locations, each location storing $Q/G$ LLR values, where $G$ is an implementation parameter that is a divisor of $Q$ and will be referred to as memory granularity factor. Fig. 29 shows the LLR memory locations and the LLRs of the first constellation for $M$=4, $F$=2, $Q$=12, and $G$ ranging from 1 to 12.

Advantageously, the number of LLR values in a memory location, i.e. Q/G, must be a multiple of F, so that the LLRs of each constellation are stored at the same position in all memory locations that contain those LLRs. This ensures that the LLRs of any constellation are stored in only $M/F$ memory locations. A counterexample can be seen in Fig. 29 for G=4, where each memory location stores 12/4=3 LLRs. The LLRs of the 2nd and 5th constellations are each stored in four memory locations instead of two.

In addition to the straightforward case of simple QAM constellations, for which 2x folding can be applied, folding is even more useful when two or more constellation symbols must be jointly decoded. Joint decoding is required for instance for the maximum-likelihood (ML) decoding of block codes, such as space-time or space-frequency codes for MIMO, or rotated constellations in two or more dimensions.

In general, a block code encodes two or more input symbols $x_1...x_k$ onto a block of two or more output symbols $y_1...y_L$., where $L$ is at least equal to $K$. Such a code can be modeled by a generator matrix $G$ with $K$ columns and $L$ rows, which left-multiplies the input signal vector $X$ to obtain the output signal vector $Y$.

$$Y = G X$$

The symbol vectors $X$ and $Y$, as well as the matrix $G$, can be real or complex. Depending on the kind of code, the elements of $Y$ can be transmitted in different time or frequency slots, over different antennas, or a combination thereof. In the receiver, ML decoding typically requires the joint decoding of all $K$ elements of $X$. Examples for block codes for MIMO (multiple-input multiple-output) communication systems include the Alamouti code, the Golden code, and spatial multiplexing.

It is evident that a folding factor of up to $K$ can be used when $K$ symbols are encoded in the same block. Moreover, if the symbols are QAM (containing two separable PAM symbols), the folding factor can be increased to $2K$.

According to a further aspect of the invention, if constellations of different sizes, i.e. hybrid constellations, are encoded jointly, the bits of the two constellations will be mapped onto different cyclic groups since they have different robustness levels.

An embodiment for such a situation is a coded spatial-multiplexing MINO system for two transmit antennas. The complex signal before coding is $X$ = [$x$1 $x$2], where $x$1 has QPSK modulation and $x$2 has 16QAM modulation. The complex signal after coding is $Y$ = [$y$1 $y$2], where $y$1 and $y$2 are the signals transmitted over the first and the second antenna respectively. *Y* is obtained from *X* by multiplication with a 2x2 generator matrix *G,* which can be real or complex.

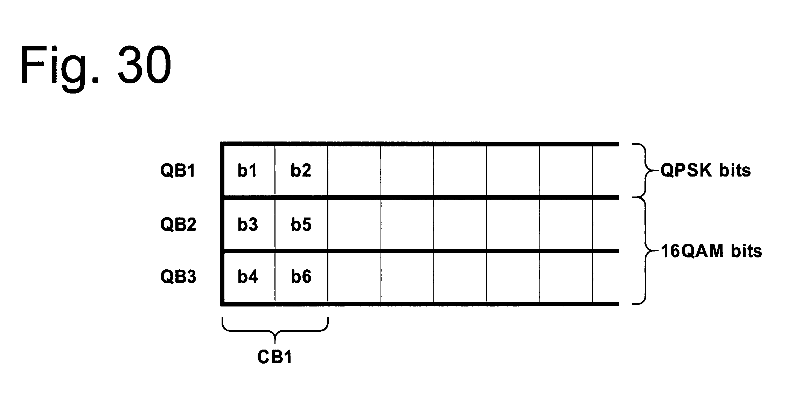

For example, when mixing QPSK and 16QAM symbols in the same code block, the mapping for a folding factor F=2 is shown in Fig. 30. Only the first 7 bits of the cyclic blocks are represented. The two complex symbols *x*1 and *x*2 have the following structure:

- *x*1: QPSK with real part given by bit *b*1 and imaginary part by bit *b*2

- *x*2: 16QAM with real part given by bits b3 and *b*4 and the imaginary part given by bits *b*5 and *b*6.

The two symbols are decoded jointly in the receiver and form a so-called constellation block or generalized constellation, denoted by CB in Fig. 30.

The entire constellation block of six bits has three robustness levels:

- Level 1, containing QPSK bits b1 and b2, mapped onto QB1

- Level 2, containing 16QAM bits b3 and b5, mapped onto QB2

- Level 3, containing 16QAM bits b4 and b5, mapped onto QB3

Although the present invention has been described by referring to specific embodiments illustrated in the enclosed figures, in particular by providing exemplary values for the key parameters N, M, and Q, the present invention is not restricted to any specific combination of such parameters. In fact, the present invention can be applied to any practically relevant combination of values (positive integers) for these parameters, such as those mentioned in the background section in the context of the DVB-T2 standard.

Further, the present invention is not restricted to any particular modulation scheme such as QPSK or QAM mentioned above, but may also be applied, for instance, to circular constellations employed in the context of DVB-S2, or to higher dimensional constellations, etc.

Further, the present invention is not restricted to a particular form for implementing the disclosed methods and devices, both in software or in hardware. Specifically, the invention may be implemented in form of a computer-readable medium having embodied thereon computer-executable instructions that are adapted for allowing a computer, a microprocessor, a microcontroller, and the like, to perform all steps of a method according to the embodiments of the present invention. The invention may also be implemented in form of an application-specific integrated circuit (ASIC) or in form of a field programmable gate array (FPGA).

Summarizing, the present invention relates to bit interleaving and de-interleaving of quasi-cyclic low-density parity-check (QC-LDPC) codes and discloses a bit interleaver that allows for a particularly efficient hardware implementation due to its high degree of parallelism. This is achieved by constructing a permutation for mapping the bits of the QC-LDPC codeword to a sequence of constellation words such that the permutation can be performed independently for each of F·N/M sections of the codeword, wherein N is the number of cyclic blocks within the codeword, M the number of bits per constellation word, and F the number of cyclic group bits that are mapped onto the same constellation word. According to a further aspect of the present invention, all bits of a given cyclic block are mapped to constellation word bits that have the same robustness level within the given set of predefined constellation points. A particularly important example is F=2 in case of a QAM constellation.

**Claims**

1. A method for bit-interleaving in a communication system with quasi-cyclic low-density parity-check codes, the method comprising the steps of
   receiving a codeword of the quasi-cyclic low-density parity-check code, the codeword consisting of *N* cyclic blocks, each cyclic block consisting of *Q* bits;
   applying a bit permutation to the bits of the codeword;
   dividing the permuted codeword into a plurality of constellation words, each constellation word consisting of *M* bits and indicating one of $2^M$ predefined constellation points,
   **characterized by**
   dividing the codeword into *F·N/M* sections, *F* being an integer greater than one, each section comprising *M/F* cyclic blocks, each constellation word being associated with a corresponding one of the sections; and
   wherein the step of applying the bit permutation is performed by applying, for each section, a section permutation to the *M·Q/F* bits of the section, the section permutation being adapted such that each constellation word is made up of $F$ bits from each of the $M/F$ cyclic blocks of the corresponding section.

2. A method according to claim 1, wherein the section permutation is adapted such that all bits of a given cyclic block are mapped to constellation word bits that have the same robustness level within the given set of predefined constellation points.

3. A method according to claim 1 or 2, wherein F is equal to the number of constellation word bits that have the same robustness level within the given set of predefined constellation points.

4. A method according to any of claims 1 to 3, wherein F=2 and the predefined constellation points represent a QAM constellation.

5. A method according to any of claims 1 to 4, wherein the step of applying the section permutation comprises applying a column-row permutation on the $M \cdot Q/F$ bits of the section.

6. A method according to claim 5, wherein the column-row permutation is a permutation equivalent to writing the $M \cdot Q/F$ bits column-wise into a matrix of Q columns and $M/F$ rows and reading out the permuted bits row-wise.

7. A method for deinterleaving a bitstream in a communication system with quasi-cyclic low-density parity-check codes, the method comprising the steps of
receiving a bit string consisting of N·Q bits;
applying an inverse bit permutation to the received bit string in order to recover a codeword of the quasi-cyclic low-density parity-check code, the inverse bit permutation being adapted for reverting the bit permutation performed by the bit-interleaving method of claims 1 to 6.

8. A bit interleaver for a communication system with quasi-cyclic low-density parity-check codes, the bit interleaver comprising:

a bit permutation unit adapted for receiving a codeword of the quasi-cyclic low-density parity-check code, the codeword consisting of $N$ cyclic blocks, each cyclic block consisting of $Q$ bits,
for applying a bit permutation to the bits of the codeword, and
for outputting the permuted codeword such that the permuted codeword is divided into a plurality of constellation words, each constellation word consisting of M bits and indicating one of $2^M$ predefined constellation points,
**characterized in that**
the bit permutation unit comprises a plurality of section permutation units, each of which is adapted for receiving the bits of $M/F$ cyclic blocks, $F$ being an integer greater than one, for applying a section permutation to the received bits, and for outputting the permuted bits such that each constellation word is made up of $F$ bits from each of $M/F$ distinct cyclic blocks,
wherein each constellation word is associated with a corresponding one of the section permutation units such that all bits of the constellation word are output by the corresponding section permutation unit only.

9. A bit interleaver according to claim 8, wherein the section permutation units are configured so that all bits of a given cyclic block are mapped to constellation word bits that have the same robustness level within the given set of predefined constellation points.

10. A bit interleaver according to claim 8 or 9, wherein F is equal to the number of constellation word bits that have the same robustness level within the given set of predefined constellation points.

11. A bit interleaver according to any of claims 8 to 10, wherein F=2 and the predefined constellation points represent a QAM constellation.

12. A bit interleaver according to any of claims 8 to 11, wherein the section permutation units are adapted for applying a column-row permutation on the $M \cdot Q/F$ received bits.

13. A deinterleaver for deinterleaving a bitstream in a communication system with quasi-cyclic low-density parity-check codes, the deinterleaver comprising an an inverse bit permutation unit adapted for receiving a bit string consisting of N·Q bits, and
for applying an inverse bit permutation to the received bit string in order to recover a codeword of the quasi-cyclic low-density parity-check code, the inverse bit permutation being adapted for reverting the bit permutation performed by the bit interleaver of any of claims 8 to 12.

**14.** A decoder for a bit-interleaved coding and modulation systems with quasi-cyclic low-density parity-check codes, the decoder comprising

a constellation demapper (2320) for generating a sequence of soft-bits indicating a probability of the corresponding bit being 0 or 1;

a deinterleaver (2330) according to claim 13 for deinterleaving the sequence of soft-bits; and

a low-density parity-check decoder (2340) for decoding the deinterleaved sequence of soft-bits.

**15.** A decoder according to claim 14, further comprising

a subtractor (2360) for subtracting the input and the output of the low-density parity-check decoder (2340); and

an interleaver (2350) according to any of claims 8 to 12 for feeding the difference between the input and the output of the low-density parity-check decoder (2340) back to the constellation demapper (2320).

# Fig. 1

Fig. 2

Fig. 3

Fig. 4

Fig. 5

# Fig. 6

**Encoded bits b1, b2, b3**

| 100 | 101 | 111 | 110 | 010 | 011 | 001 | 000 |

**Subsets for b1=1 (black), b1=0 (white)**

| 100 | 101 | 111 | 110 | 010 | 011 | 001 | 000 |

**Subsets for b2=1 (black), b2=0 (white)**

| 100 | 101 | 111 | 110 | 010 | 011 | 001 | 000 |

**Subsets for b3=1 (black), b3=0 (white)**

| 100 | 101 | 111 | 110 | 010 | 011 | 001 | 000 |

EP 2 525 498 A1

# Fig. 7

| QB1 | QB2 | QB3 | QB4 | QB5 | QB6 | QB7 | QB8 | QB9 | QB10 | QB11 | QB12 |

**Bit Interleaver**

C1 C2 C3 C4 C5 C6 C7 C8 C9 C10 C11 C12 C13 C14 C15 C16 C17 C18 C19 C20 C21 C22 C23 C24

# Fig. 8A

# Fig. 8B

EP 2 525 498 A1

# Fig. 9B

Read

Row 1 → ■

Column 1 ········· Column 12

Row 1350

# Fig. 9A

Write

Row 1 → ■

Column 1 ········· Column 12

Row 1350

# Fig. 10B

**Read**

Column 8 · · · · · · Column 1

Row 1 → · · · · · · · · · · · · · · Row 2025

# Fig. 10A

**Write**

Column 8 · · · · · · Column 1

Row 1 · · · · · · · · · · · · · · · Row 2025

Fig. 11

EP 2 525 498 A1

# Fig. 12

64QAM cell word: $y_0$, $y_1$, $y_2$, $y_3$, $y_4$, $y_5$

Simple DEMUX

DEMUX Permutation

$v_0$, $v_1$, $v_2$, ...

$v_{0,0}$, $v_{0,1}$, $v_{0,2}$, ...
$v_{1,0}$, $v_{1,1}$, $v_{1,2}$, ...
$v_{2,0}$, $v_{2,1}$, $v_{2,2}$, ...
$v_{3,0}$, $v_{3,1}$, $v_{3,2}$, ...
$v_{4,0}$, $v_{4,1}$, $v_{4,2}$, ...
$v_{5,0}$, $v_{5,1}$, $v_{5,2}$, ...
$v_{6,0}$, $v_{6,1}$, $v_{6,2}$, ...
$v_{7,0}$, $v_{7,1}$, $v_{7,2}$, ...
$v_{8,0}$, $v_{8,1}$, $v_{8,2}$, ...
$v_{9,0}$, $v_{9,1}$, $v_{9,2}$, ...
$v_{10,0}$, $v_{10,1}$, $v_{10,2}$, ...
$v_{11,0}$, $v_{11,1}$, $v_{11,2}$, ...

$b_{0,0}$, $b_{0,1}$, $b_{0,2}$, ...
$b_{1,0}$, $b_{1,1}$, $b_{1,2}$, ...
$b_{2,0}$, $b_{2,1}$, $b_{2,2}$, ...
$b_{3,0}$, $b_{3,1}$, $b_{3,2}$, ...
$b_{4,0}$, $b_{4,1}$, $b_{4,2}$, ...
$b_{5,0}$, $b_{5,1}$, $b_{5,2}$, ...
$b_{6,0}$, $b_{6,1}$, $b_{6,2}$, ...
$b_{7,0}$, $b_{7,1}$, $b_{7,2}$, ...
$b_{8,0}$, $b_{8,1}$, $b_{8,2}$, ...
$b_{9,0}$, $b_{9,1}$, $b_{9,2}$, ...
$b_{10,0}$, $b_{10,1}$, $b_{10,2}$, ...
$b_{11,0}$, $b_{11,1}$, $b_{11,2}$, ...

$y_{0,0}$, $y_{0,2}$, $y_{0,4}$, ...
$y_{1,0}$, $y_{1,2}$, $y_{1,4}$, ...
$y_{2,0}$, $y_{2,2}$, $y_{2,4}$, ...
$y_{3,0}$, $y_{3,2}$, $y_{3,4}$, ...
$y_{4,0}$, $y_{4,2}$, $y_{4,4}$, ...
$y_{5,0}$, $y_{5,2}$, $y_{5,4}$, ...
$y_{0,1}$, $y_{0,3}$, $y_{0,5}$, ...
$y_{1,1}$, $y_{1,3}$, $y_{1,5}$, ...
$y_{2,1}$, $y_{2,3}$, $y_{2,5}$, ...
$y_{3,1}$, $y_{3,3}$, $y_{3,5}$, ...
$y_{4,1}$, $y_{4,3}$, $y_{4,5}$, ...
$y_{5,1}$, $y_{5,3}$, $y_{5,5}$, ...

To mapper

To mapper

Bit-to-cell DEMUX

# Fig. 13

256QAM cell word: $y_0, y_1, y_2, y_3, y_4, y_5, y_6, y_7$

Fig. 14

EP 2 525 498 A1

# Fig. 15

Cyclic blocks (1...45)

Bits in cyclic block (1...72)

Column 1
Column 2
Column 3
Column 4
Column 5
Column 6
Column 7
Column 8
Column 9
Column 10
Column 11
Column 12

EP 2 525 498 A1

Fig. 16

# Fig. 17

EP 2 525 498 A1

# Fig. 18

QB1

QB2

QB3    Section 1
       mapped to C 1...C8

QB4

QB5

QB6    Section 2
       mapped to C 9...C16

QB7

QB8

QB9

QB10

QB11   Section 3
       mapped to C 17...C24

QB12

EP 2 525 498 A1

Fig. 19

# Fig. 20A

QB1  QB2  QB3  QB4

Intra-QB Perm. 1  Intra-QB Perm. 2  Intra-QB Perm. 3  Intra-QB Perm. 4

C1  C2  C3  C4  C5  C6  C7  C8

# Fig. 20B

| | |
|---|---|
| QB1 | $b_1$ of C1...C8 |
| QB2 | $b_2$ of C1...C8 |
| QB3 | $b_3$ of C1...C8 |
| QB4 | $b_4$ of C1...C8 |

Section 1

# Fig. 20C

| | C1 | C2 | C3 | C4 | C5 | C6 | C7 | C8 |
|---|---|---|---|---|---|---|---|---|
| QB1 | b1 | b1 | b1 | b1 | b1 | b1 | b1 | b1 |
| QB2 | b2 | b2 | b2 | b2 | b2 | b2 | b2 | b2 |
| QB3 | b3 | b3 | b3 | b3 | b3 | b3 | b3 | b3 |
| QB4 | b4 | b4 | b4 | b4 | b4 | b4 | b4 | b4 |

Section 1

EP 2 525 498 A1

Fig. 21

Fig. 22

# Fig. 23A

```
[2310]              [2320]              [2330]              [2340]
Demodulator  →  Constellation  →      Bit        →       LDPC
                 Demapper          Deinterleaver          Decoder
```

Non-Iterative BICM Decoder

# Fig. 23B

```
[2310]              [2320]              [2330]              [2340]
Demodulator  →  Constellation  →      Bit        →       LDPC
                 Demapper          Deinterleaver          Decoder
```

Extrinsic
Information

Bit
Interleaver

2350    2360

Iterative BICM Decoder

EP 2 525 498 A1

Fig. 24

# Fig. 25

EP 2 525 498 A1

# Fig. 26A

Without folding

Section 1

| | b1 C1 | b1 C2 | b1 C3 | b1 C4 | b1 C5 | b1 C6 | b1 C7 | b1 C8 |
|---|---|---|---|---|---|---|---|---|
| QB1 | b1 C1 | b1 C2 | b1 C3 | b1 C4 | b1 C5 | b1 C6 | b1 C7 | b1 C8 |
| QB2 | b2 C1 | b2 C2 | b2 C3 | b2 C4 | b2 C5 | b2 C6 | b2 C7 | b2 C8 |
| QB3 | b3 C1 | b3 C2 | b3 C3 | b3 C4 | b3 C5 | b3 C6 | b3 C7 | b3 C8 |
| QB4 | b4 C1 | b4 C2 | b4 C3 | b4 C4 | b4 C5 | b4 C6 | b4 C7 | b4 C8 |

# Fig. 26B

With 2x folding

| | | | | | | | | | Section |
|---|---|---|---|---|---|---|---|---|---|
| QB1 | b1 C1 | b3 C1 | b1 C2 | b3 C2 | b1 C3 | b3 C3 | b1 C4 | b3 C4 | Section 1 |
| QB2 | b2 C1 | b4 C1 | b2 C2 | b4 C2 | b2 C3 | b4 C3 | b2 C4 | b4 C4 | |
| QB3 | b1 C5 | b3 C5 | b1 C6 | b3 C6 | b1 C7 | b3 C7 | b1 C8 | b3 C8 | Section 2 |
| QB4 | b2 C5 | b4 C5 | b2 C6 | b4 C6 | b2 C7 | b4 C7 | b2 C8 | b4 C8 | |

EP 2 525 498 A1

Fig. 27A

Fig. 27B

EP 2 525 498 A1

Fig. 28

Fig. 29

Fig. 30

QPSK bits

16QAM bits

QB1   b1   b2

QB2   b3   b5

QB3   b4   b6

CB1

| | Europäisches Patentamt European Patent Office Office européen des brevets | **EUROPEAN SEARCH REPORT** | Application Number EP 11 00 4127 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2010/024914 A1 (THOMSON LICENSING [FR]; LEI JING [US]; GAO WEN [US]) 4 March 2010 (2010-03-04) * page 1 - page 24; figures 1-6 * ----- | 1-15 | INV. H03M13/25 H03M13/27 H03M13/35 |
| A | FRANK KIENLE ET AL: "Macro Interleaver Design for Bit Interleaved Coded Modulation with Low-Density Parity-Check Codes", PROC., IEEE VEHICULAR TECHNOLOGY CONFERENCE, VTC, SPRING 2008, 11 May 2008 (2008-05-11), pages 763-766, XP031255631, ISBN: 978-1-4244-1644-8 * the whole document * ----- | 1-15 | |
| A | HUA RUI ET AL: "Performance of belief propagation coded modulation with iterative decoding", PROC., IEEE INTERNAT IONAL CONFERENCE ON COMMUNICATIONS, CIRCUITS AND SYSTEMS, ICCCAS 2004, CHENGDU, CHINA, 27 June 2004 (2004-06-27), - 29 June 2004 (2004-06-29), pages 71-74VOL.1, XP010731793, DOI: 10.1109/ICCCAS.2004.1345942 ISBN: 978-0-7803-8647-1 * page 71 - page 73; figure 1 * ----- -/-- | 1-15 | TECHNICAL FIELDS SEARCHED (IPC) H03M H04L |

The present search report has been drawn up for all claims

| Place of search | Date of completion of the search | Examiner |
|---|---|---|
| Munich | 24 October 2011 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 11 00 4127

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TAKASHI YOKOKAWA ET AL: "Parity and column twist bit interleaver for DVB-T2 LDPC codes", 5TH INTERNATIONAL SYMPOSIUM ON TURBO CODES AND RELATED TOPICS, BREST, FRANCE, 1 September 2008 (2008-09-01), pages 123-127, XP031353674, DOI: 10.1109/TURBOCODING.2008.4658684 ISBN: 978-1-4244-2862-5 * the whole document * | 1-15 | |
| A | YATES R ET AL: "Demultiplexer design for multi-edge type LDPC coded modulation", INFORMATION THEORY, 2009. ISIT 2009. IEEE INTERNATIONAL SYMPOSIUM ON, IEEE, PISCATAWAY, NJ, USA, 28 June 2009 (2009-06-28), pages 933-937, XP031513310, ISBN: 978-1-4244-4312-3 * the whole document * | 1-15 | |
| A | DIVSALAR D ET AL: "Protograph Based Low Error Floor LDPC Coded Modulation", PROC., IEEE CONFERENCE ONMILITARY COMMUNICATIONS, MILCOM 2005, ATLANTIC CITY, NJ, USA, 17 October 2005 (2005-10-17), - 20 October 2005 (2005-10-20), pages 1-8, XP010901298, DOI: 10.1109/MILCOM.2005.1605713 ISBN: 978-0-7803-9393-6 * the whole document * | 1-15 | TECHNICAL FIELDS SEARCHED (IPC) |

The present search report has been drawn up for all claims

| Place of search | Date of completion of the search | Examiner |
|---|---|---|
| Munich | 24 October 2011 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 11 00 4127

This annex lists the patent family members relating to the patent documents cited in the above-mentioned European search report.
The members are as contained in the European Patent Office EDP file on
The European Patent Office is in no way liable for these particulars which are merely given for the purpose of information.

24-10-2011

| Patent document cited in search report | Publication date | Patent family member(s) | Publication date |
|---|---|---|---|
| WO 2010024914    A1 | 04-03-2010 | NONE | |

EPO FORM P0459

For more details about this annex : see Official Journal of the European Patent Office, No. 12/82